# EUROPEAN PATENT APPLICATION

(11) **EP 2 096 902 A1**
(43) Date of publication of application: **02.09.2009**
(21) Application number: 07741898.6
(22) Date of filing: 18.04.2007
(51) Int. Cl.: H05B 37/02, H01L 33/00

(54) **ILLUMINATING DEVICE**

(30) Priority: 18.12.2006 JP 2006340422; 12.04.2007 JP 2007105488
(71) Applicant: MoMo Alliance Co.Ltd., Okayama-shi Okayama 700-0024 (JP)
(72) Inventor: NAKAYAMA, Sadatsugu, Okayama 700-0024 (JP); NAGAMUNE, Sigeru, Okayama 700-0024 (JP); FUJIWARA, Akira, Okayama 700-0024 (JP); MAKABE, Atsushige, Okayama 700-0024 (JP); SIGESADA, Masaru, Okayama 700-0024 (JP); KATAOKA, Naoki, Okayama 700-0024 (JP); ITO, Hiroshi, Okayama 700-0024 (JP); KAWAI, Yukitoshi, Okayama 700-0024 (JP)
(74) Representative: Pautex Schneider, Nicole Véronique
(86) International application number: PCT/JP2007/058462
(87) International publication number: WO 2008/026347

(57) **Abstract**

The lighting apparatus according to the present invention is a lighting apparatus (100) which lights by emitting light through solid-state light-emitting devices using an AC power source, the lighting apparatus including an AC to DC conversion unit which converts AC from the power source into DC, and a power source device (1) which includes a rectangular main single-side mounting board, on which a part of the AC to DC conversion unit is mounted, and a rectangular first single-side mounting sub-board, on which a remaining part of the AC to DC conversion unit is mounted, the power source device (1) being shaped like a chopstick box laid out such that the long, rectangular mounting surface of the main single-side mounting board and the rectangular first single-side mounting sub-board face each other along a length-wise direction.

## Description

### Technical Field

The present invention relates to a lighting apparatus and specifically to a lighting apparatus which uses an alternating-current power source and utilizes solid-state light-emitting devices such as a light-emitting diode as a light source.

### Background Art

In recent years there is an increase in consciousness regarding the natural environment, and therefore solid-state light-emitting devices, especially light-emitting diodes, are in focus as new light sources which can replace lamp types such as incandescent light bulbs, fluorescent lamps and mercury lamps. This is because light-emitting diodes are light sources with a long life compared to the lamp types above, and do not include harmful material such as mercury or lead. In other words light-emitting diodes are light sources that are easy on the environment.

In light-emitting devices, high-powered light-emitting diodes (below, LED) which have an input capacity of greater than 1 W are most appropriate for lighting with strong light emission. Additionally, the light conversion rate of LEDs improves every year, and there are high expectations that lighting using LED as a light source can be used as a low energy light source in the future.

For powering an LED, a constant current type direct-current (DC) power source should ideally be used. This is because the LED is a solid-state light-emitting device and the strength of light emission is determined according to the current value supplied. Thus, a constant current type DC power source for which the current value can be defined is optimal for operating an LED. Since LEDs are significantly small in comparison to a conventional fluorescent lamp and so on, the size can be established arbitrarily by arbitrarily selecting the amount of LEDs. Thus, the smaller the power source unit is in the lighting apparatus using an LED as a light source, the better.

Thus, power source devices have been proposed which supply power to a light-emitting diode after an increase or decrease in voltage by adjusting the DC voltage supplied from the DC power source to the forward voltage of the light-emitting diode as a power source that operates an LED with constant current (for example, Patent Reference 1).

Additionally, constant current DC power source devices which supply current to a light-emitting diode after performing full-wave rectification on the alternating-current (AC) power and transforming the AC power into DC using a smoothing capacitor, pulsating the DC and subsequently performing a predetermined process have been proposed as constant current DC power source devices that can be powered by a commercial power source (for example, Patent Reference 2).

Additionally, backlight devices have been proposed which utilize a constant current power source powered by a commercially available power source (for example, Patent Document 3). The DC power source device according to Patent Reference 3 is not a constant current type; however, a DC power source which does not need a smoothing capacitor has been achieved.
Patent Reference 1: Japanese Laid-Open Patent 2006-210835 Publication
Patent Reference 2: Japanese Laid-Open Patent 8-241133 Publication
Patent Reference 3: Japanese Laid-Open Patent 2004-303431 Publication

### Disclosure of Invention

### Problems that Invention is to Solve

However, there is the problem that the miniaturization of lighting apparatuses utilizing solid-state light-emitting devices, such as a light-emitting diode used as a light source, is not adequate.

In the lighting apparatus (below, described as an LED lighting apparatus) which utilizes a solid-state light-emitting device such as a light-emitting diode as a light source in the above Patent Reference 1, the DC power source is a power source for powering the LED. However, the power source is generally a commercial-use power source when using an LED as a light source for a household or a business, or as a light source for an advertising display apparatus such as an apparatus inside a station. The commercial-use power source is an AC power source. The LED lighting apparatus which uses the DC power source as the power source in the above Patent Reference 1 cannot use an AC power source and requires a power source device which transforms the alternating-current of the commercial-use power source into DC besides the LED lighting apparatus, and thus cannot be adequately miniaturized.

Therefore a capacitor with a large capacity is generally used for a smoothing capacitor. The volume of the electrolyte capacitor is large and for this reason the apparatus tends to have a large size. Capacity changes also occur in the electrolyte capacitor due to the surrounding temperature. As a result, there is the problem that the reliability of the apparatus which uses the electrolytic capacitor is low and the life of the apparatus tends to be shortened.

A smoothing capacitor is utilized in the constant current DC power source in the above Patent Reference 2. As a result, the constant current DC power source in the above Patent Reference 2 cannot be adequately miniaturized. Further, the reliability of the constant current DC power source in the above Patent Reference 2 is not high.

Additionally, the DC power source in the backlight device in the above Patent Document 3 does not use a smoothing capacitor as above, however no consideration is given to a solid-state light-emitting device such as an LED. Thus in the LED lighting apparatus to which the DC power source in the above Patent Reference 3 is applied cannot be adequately miniaturized.

Further, the long-life characteristic of the LED is one of its features. Thus, it is possible to use the LED for more than 10 years depending on utilization. Thus, the apparatus which powers the LED is expected to have reliability, such as stability, over a long period. The DC power source in the backlight device in the above Patent Document 3 is not built in consideration of stability over a long period. Thus the reliability of the LED lighting apparatus to which the power source device in Patent Document 3 above is applied is not high.

The present invention is realized in view of the above circumstances and has an object of providing a lighting apparatus which utilizes an adequately miniaturized power source device which can operate an LED appropriately with high reliability using an AC power source.

### Means to Solve the Problems

In order to achieve the object above, the lighting apparatus in the present invention lights by causing solid-state light-emitting devices to emit light using an AC power source, the lighting apparatus including: a power source device which includes: an AC to DC conversion unit which converts AC from a power source into DC; a main single-side mounting board having a rectangular shape, on which a part of the AC to DC conversion unit is mounted; and a first single-side mounting sub-board having a rectangular shape, on which a remaining part of the AC to DC conversion unit is mounted; and the power source device is shaped like a chopstick box and composed such that the mounting surface of the main single-side mounting board and the mounting surface of the first single-side mounting sub-board are laid out such that the mounting surfaces face each other along a length-wise direction.

Given this structure, the volume of the power source device which uses a light source using solid-state light-emitting devices can be reduced to approximately the size of a chopstick box (i.e. a box that is small, slim, and rectangular in shape) by densely mounting circuit parts of the AC to DC conversion unit on single-side mounting boards. In other words, a lighting apparatus can be achieved which uses a power source that is adequately miniaturized.

Here, the AC to DC conversion unit may include: an undulating voltage conversion unit which converts sine wave voltage from the power source into an undulating voltage; a switch unit which controls a duty cycle which is a ratio between ON time in which, the undulating voltage outputted from the undulating voltage conversion unit is allowed to pass, and OFF time in which the undulating voltage is not allowed to pass; a transformer which transforms voltage of the undulating voltage from the switch unit; and a smoothing unit which smoothes the voltage transformed by the transformer.

However, the volume of the electrolytic capacitor used by the smoothing capacitor is large since a large capacity is required. The electrolytic capacitor used by the smoothing capacitor easily changes capacity due to the effects of room temperature and thus the dependability of the power source device which uses the electrolytic capacitor is not high. Given this structure, there is no need to use a smoothing capacitor for circuit parts that use an AC power source to convert AC to DC, which are large and do not have high reliability; the power source device which uses a light source using solid-state light-emitting devices can be miniaturized and the reliability improved.

Here, the power source device may further include: a second single-side mounting sub-board; a photo coupler; a microcomputer unit which controls the duty cycle through the photo coupler for the switch unit; a microcomputer power source unit which powers the microcomputer unit, and the microcomputer unit and the microcomputer power source unit are mounted on the second single-side mounting sub-board, and the mounting surface of main single-side mounting board and the mounting surface of the second single-side mounting sub-board is laid out so such that mounting surfaces face each other along a length-wise direction.

Given this structure, the microcomputer source unit and the microcomputer power source unit which powers the microcomputer source unit can be electrically insulated from the AC to DC conversion unit by separating the one-side mounting board on which the microcomputer source unit and the microcomputer power source unit which powers the microcomputer source unit are mounted from the one-side mounting board on which the AC to DC conversion unit is mounted and using a photocoupler. Thus the security of the power source device in the lighting apparatus can be raised, breakdowns can be prevented and the reliability of the apparatus can be improved.

Here, a height of the power source device may be approximately equal to a height of a first circuit which is the tallest among circuit parts included in the AC to DC conversion unit, and a length of a short side of the power source device may be approximately equal to a length of a second circuit part which is the widest among the circuit parts included in the AC to DC conversion unit.

Given this structure, the size of the power source device included in the lighting apparatus can be minimized. Thus, a lighting apparatus using a power source that is adequately miniaturized can be achieved.

Note that the first and the second circuit part may be the same circuit part and may be transformers.

Given this structure, an adequately miniaturized power source device can be achieved since the circuit parts which compose the power source device can be laid out optimally on the one-side mounting board with the size and height of the transformer as maximum size and height limits.

Here, the power source device may include a detecting unit which detects temperature, and the microcomputer unit may control the switch unit to shorten the ON time when a temperature detected by the detecting unit exceeds a first temperature. Here, the power source device includes a detecting unit which detects temperature, and the microcomputer unit may control the switch unit to lengthen the ON time when a temperature detected by the detecting unit falls short of a second temperature.

Given this structure, when the temperature range at which the lighting apparatus is securely powered includes a first temperature which is an upper limit and a second temperature which is a lower limit, and when the temperature detected by the power source device diverges from the temperature range at which the lighting apparatus is securely powered, temperature adjustment is performed by the microcomputer unit controlling the switch unit such that the temperature becomes less than or equal to the first temperature or greater than or equal to the second temperature. Thus, the lighting apparatus is adequately powered in a safe operation range of the lighting apparatus and thus the security of the lighting apparatus can be raised and breakdowns prevented. In other words, the reliability of the lighting apparatus can be improved.

Here, the temperature detected by the detecting unit may be a temperature of the transformer.

Given this structure, the lighting apparatus can be adequately powered in a safe operation range, raising the security of the lighting apparatus and preventing breakdowns by detecting the temperature of the transformer, which easily heats up, among the circuit parts which compose the lighting apparatus. Thus, the stability of the lighting apparatus 1 can be raised and breakdowns can be prevented.

Here, the power source device may include a casing shaped like a chopstick box in which the main single-side mounting board and the first single-side mounting sub-board are housed, the casing being small, slim, and rectangular in shape. Here, the temperature detected by the detecting unit may be a temperature of the casing.

However, when the casing 71 has an abnormally high temperature, the possibility that the power source device will experience breakdown is high. Given this structure, the lighting apparatus can ensure that the temperature of the power source device does not become abnormally high by the detection unit detecting the temperature of the casing 71. Thus, the stability of the lighting apparatus 1 can be raised and breakdowns can be prevented.

Here, the power source device may further include a current voltage detecting unit which detects voltage and current impressed to the solid-state light-emitting devices from the smoothing unit, and when a product of the current value and the voltage value detected by the current voltage detecting unit deviates from a predetermined range, the microcomputer unit may control the switch unit to modify the duty cycle. Here, the microcomputer unit may control the switch unit to shorten ON time when the product of the current value and the voltage value detected by the current voltage detecting unit exceeds a threshold value; and the microcomputer unit may control the switch unit such that when a product of the current value and the voltage value detected by the current voltage detecting unit meets a threshold value, the current value becomes the smallest current value at which the solid-state light-emitting devices can emit light.

Thus when the detected current value and voltage value diverge from a range of values in the product of the current value and the voltage value powered safely by the lighting apparatus, the current value and voltage value are adjusted and the product value of the current value and the voltage value is adjusted by the microcomputer unit controlling the switch unit. Thus, since the lighting apparatus can be adequately powered in the safe operation range of the lighting apparatus, the security of the lighting apparatus can be raised and breakdowns prevented. In other words, the reliability of the lighting apparatus can be improved.

Here, directly after the lighting apparatus is powered on, the microcomputer unit may control the switch unit to successively lengthen ON time until the product of the current value and the voltage value detected by the current voltage unit reaches a target value as an initial process.

Thus after the lighting apparatus is turned on, the current and voltage applied to the solid-state light-emitting devices of the lighting apparatus can be successively increased until the current and voltage values become the product value of the target current value and target voltage value of the lighting apparatus. Accordingly, compared to when a target current value and target voltage are immediately applied, current and voltage can be applied until the current value and the voltage value reach the target current value and target voltage value for the lighting apparatus, without applying excessive current and voltage to the power source device and the solid-state light-emitting devices. Thus, the security of the lighting apparatus can be raised and breakdowns can be prevented.

Here, the microcomputer unit may cause a storage unit to store the current value, the voltage value and the duty cycle in the initial process as a history.

Thus, since the target value, which is the product of an adequate current value and voltage value applied to the solid-state light-emitting devices, is learned, each time the lighting apparatus is turned on, there is no longer a need to successively approximate the current value and the voltage value, which are appropriate target values applied to the solid-state light-emitting devices. Therefore, current and voltage is applied to the solid-state light-emitting devices directly after the power is turned on and the time until the value reaches the appropriate target value can be reduced.

Additionally, the transformer may have a center-tap on a first coil side, the undulating voltage conversion unit may include a full-wave rectifier which outputs the undulating voltage between an end of a first coil in the transformer and the center-tap, and between another end of the first coil and the center-tap; the switch unit may include a first switch and a second switch, the first switch may be inserted in wiring which connects the undulating voltage conversion unit and the end of the first coil, and the second switch may be inserted in wiring which connects the undulating voltage conversion unit and the other end of the first coil.

Given this structure, the transformer can be prevented from being unnecessarily magnetized since the transformer can be composed such that the direction of magnetic flux generated between one end of the first coil and the center tap, and the other end of the first coil and the center tap in the transformer is reversed. Thus the durability of the power source device can be improved, and the reliability of the power source device rises.

Additionally, the microcomputer unit may control starting AC power supply to the AC to DC conversion unit.

However, the frequency of an AC power source in Japan differs in east Japan, 50Hz, from west Japan, 60Hz, and in order to perform the desired control on the AC to DC conversion unit, the frequency of the AC power source must be detected. Given this structure, the frequency of the AC power source can be detected before the AC to DC conversion unit operates.

Additionally, given this structure, when an error occurs in the AC to DC conversion unit, or the solid-state light-emitting devices in the lighting apparatus, the operation of the lighting apparatus can be stopped immediately. Thus the security of the power source device can be improved, and the reliability of the power source device rises.

Additionally, the microcomputer unit may control stopping AC power supply to the AC to DC conversion unit.

Given this structure, when an error occurs in the AC to DC conversion unit, or the solid-state light-emitting devices in the lighting apparatus, the error can be detected without fail. Thus the security of the power source device can be improved, and the reliability of the power source device rises.

Additionally, the casing may be composed of metal. Ideally, the lighting apparatus includes a light-emitting unit which emits light through the solid-state light-emitting devices, a holding unit which holds the solid-state light-emitting devices in the light-emitting unit; the light-emitting unit and the holding unit are composed of metal, and the holding unit and the casing are combined together.

Given this structure, the lighting apparatus can transmit heat given off from the solid-state light-emitting devices which compose the lighting apparatus to the casing through the light-emitting unit and the holding unit. Thus, the heat radiation of the solid-state light-emitting devices and the light-emitting device holding unit can be improved. Additionally, since the detection unit can detect the temperature of the solid-state light-emitting devices, the solid-state light-emitting devices can be powered within a safe operating range of temperature. In other words, the security of the lighting apparatus can be increased and the reliability of the lighting apparatus improved.

Note that the present invention can not only be realized as an apparatus, but as a design assistance method which breaks a design process for composing the apparatus into steps, as a program which executes the steps on a computer and as information, data or a signal which indicates the program. Subsequently, the program, information, data and the signal may be transmitted through communication media such as a recording medium such as a CD-Rom, or the Internet.

### Effects of the Invention

According to the present invention, a lighting apparatus can be realized which can appropriately operate an LED using an AC power source, has a high reliability and utilizes an adequately miniaturized power source device.

### Brief Description of Drawings

FIG. 1 is a diagonal-view diagram which shows an exterior view of the lighting apparatus according to the first embodiment of the present invention;
FIG. 2 is a diagonal-view diagram which shows a conceptual view of the power source according to the first embodiment of the present invention;
FIG. 3 is an overhead diagram seen from the side of the lighting apparatus according to the first embodiment of the present invention;
FIG. 4 is a cross-section diagram which shows the structure of the lighting apparatus according to the first embodiment of the present invention;
FIG. 5 is a cross-section diagram which shows the structure of the lighting apparatus according to the first embodiment of the present invention;
FIG. 6 is a functional block diagram for the lighting apparatus according to the first embodiment of the present invention;
FIG. 7 is a diagram which shows the conceptual circuit structure of the lighting apparatus according to the first embodiment of the present invention;
FIG. 8(a) is a diagram which shows the AC voltage waveform according to the first embodiment of the present invention; FIG. 8(b) is a diagram which describes the output waveform of the diode bridge which rectifies current according to the first embodiment of the present invention;
FIG. 9 is a flowchart which shows the functions of the lighting apparatus according to the first embodiment of the present invention;
FIG. 10(a) is a diagram which shows the initial light intensity at the base operation point for the light-emitting unit according to the first embodiment of the present invention; FIG. 10(b) is a diagram which describes settings changes for the base operation point when the light intensity of the light-emitting unit according to the first embodiment of the present invention is increased; FIG. 10(c) is a diagram which describes settings changes for the base operation point when the light intensity of the light-emitting unit according to the first embodiment of the present invention is reduced;
FIG. 11(a) is a diagram which describes that an "a" unit control signal is generated in order to control the duty cycle for the conversion unit 4 using the controller unit according to the first embodiment of the present invention; FIG. 11(b) is a diagram which describes that a "b" unit control signal is generated in order to control the duty cycle for the conversion unit 4 using the controller unit according to the first embodiment of the present invention;
FIG. 12(a) is a diagram which shows the pulse shape waveform for the "a" unit based on the control signal according to the first embodiment of the present invention; FIG. 12(b) is a diagram which shows the pulse shape waveform for the "b" unit based on the control signal according to the first embodiment of the present invention;

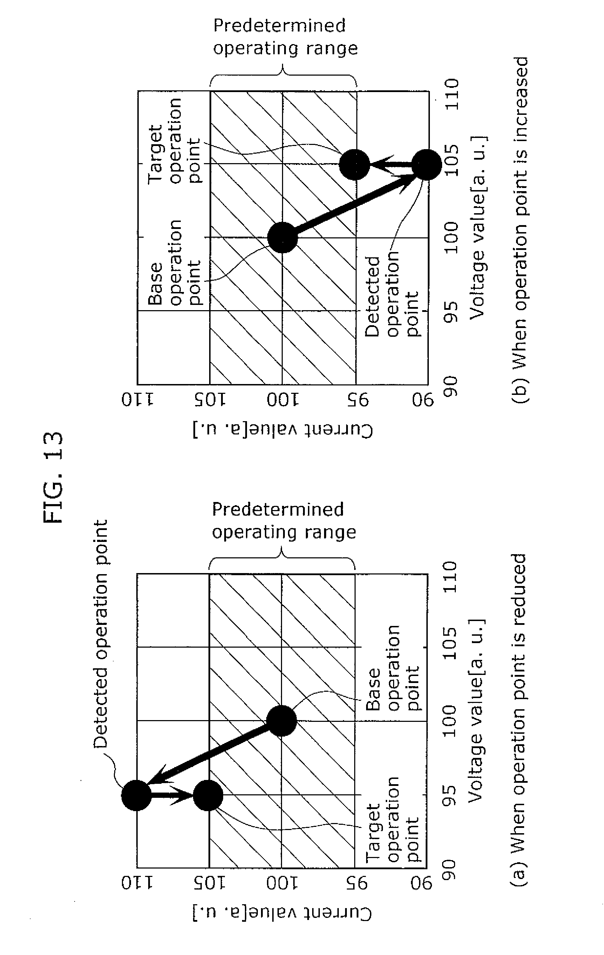

FIG. 13 (a) is a diagram which describes that the target operation point is re-established when the actually detected operation point of the light-emitting unit according to the first embodiment of the present invention exceeds and deviates from a predetermined operation range from the base operation point; FIG. 13 (b) is a diagram which describes that the target operation point is re-established when the operation point of the actually detected light-emitting unit according to the first embodiment of the present invention falls short of a predetermined operation range from the base operation point;
FIG. 14 is a flowchart which illustrates the order in which the duty cycle is modified based on the temperature detected by a detecting unit 6 according to the first embodiment of the present invention;
FIG. 15 is a flowchart which illustrates the operations performed by the lighting apparatus 100 when the base operation point of the lighting apparatus 100 according to the first embodiment of the present invention is modified;
FIG. 16 is a flowchart which shows a process depending on the amount of processes after modification of the base operation point of the lighting apparatus 100 according to the first embodiment of the present invention;
FIG. 17 is a diagram which shows a conceptual structure of the board which includes the power source device according to the first embodiment of the present invention;
FIG. 18 is a diagram which shows a casing in which circuit parts of various types are mounted to a board included in the power source device according to the first embodiment of the present invention;
FIG. 19 is a diagram which shows that the main board and the sub-boards are arranged to be facing each other on their mounting surfaces according to the first embodiment of the present invention;
FIG. 20 is a flowchart which shows a sequence in which the size of the board included in the power source device according to the first embodiment of the present invention is minimized;
FIG. 21 is a diagram which shows a conceptual view of an advertising display apparatus 141 to which a power source device 1 is mounted according to a modification of the first embodiment of the present invention; and
FIG. 22 is a cross-section diagram which shows the structure of the advertising display apparatus 141 to which a power source device 1 is mounted according to the modification of the first embodiment of the present invention.

### Numerical References

- 1: Power source device
- 2: Commercial power source
- 3: Rectifying unit
- 4: Conversion unit
- 5: Smoothing unit
- 6: Detecting unit
- 7: instructing unit
- 8: selecting unit
- 9: Setting unit
- 10: Light-emitting unit
- 21, 22: Inductor
- 23, 33: Capacitor
- 24: Diode bridge
- 25, 27: Driver
- 26, 28: FET
- 29, 36: Transformer
- 31, 32, 37: Diode
- 34, 35: Resistance
- 38: Controller unit
- 40: Board
- 41: Main board
- 42, 43: Sub-board
- 71: Casing
- 72: Socket
- 100: Lighting apparatus
- 101: Power source unit
- 102: External input switch
- 132: Light-emitting unit
- 133: Casing unit
- 134, 144: Solid-state light-emitting device
- 135, 145: Board
- 136: Protective translucent board
- 141: Advertising display apparatus
- 142: Light-emitting surface
- 143: Frame unit
- 146: Light conductor
- 147: Film

### Best Mode for Carrying Out the Invention

Below, the lighting apparatus according to the present invention is described with reference to the drawings.

### (First Embodiment)

First, the structure of the lighting apparatus according to the first embodiment of the present invention is described.

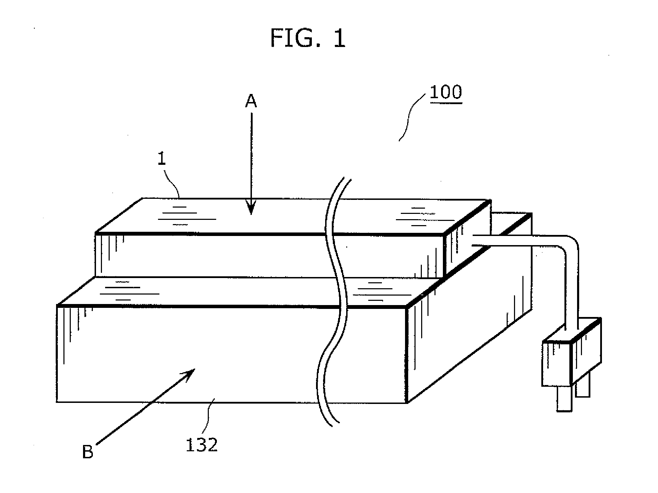

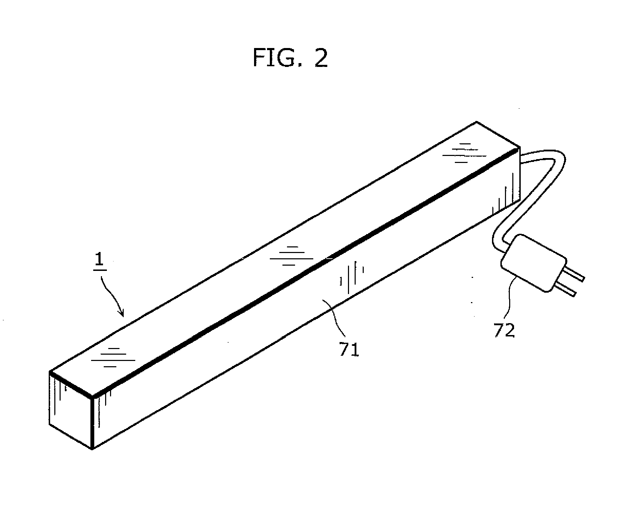

FIG. 1 is a diagonal-view diagram which shows an exterior view of the lighting apparatus according to the first embodiment of the present invention. FIG. 2 is a diagonal-view diagram which shows an external view of the power source according to the first embodiment of the present invention.

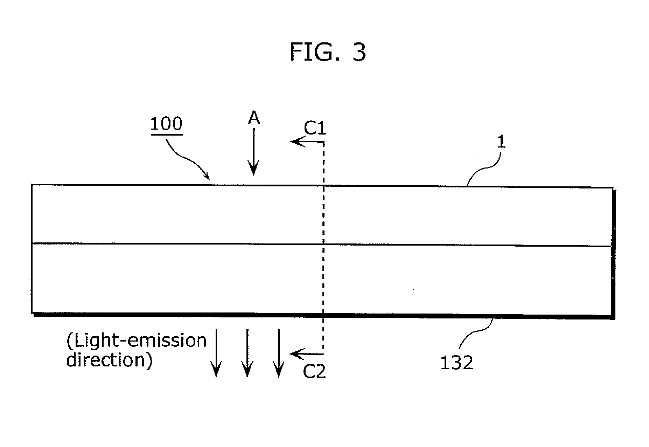

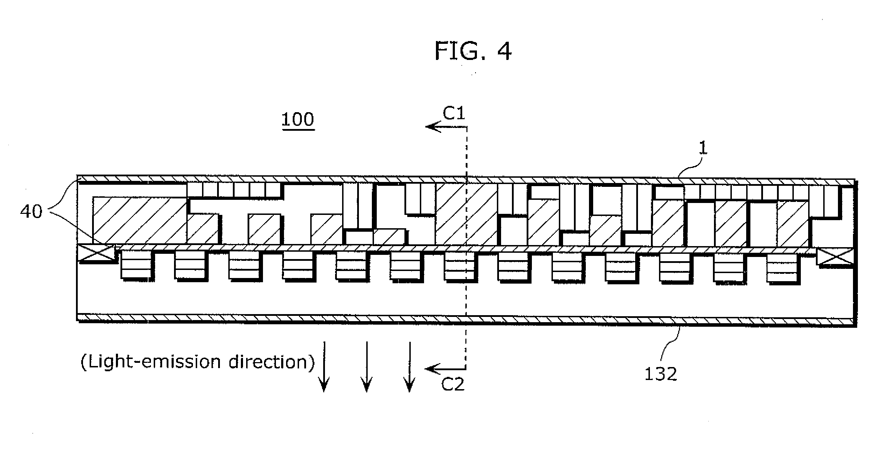

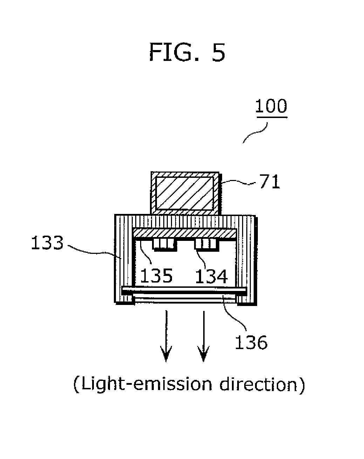

FIG. 3 is an overhead diagram seen from the side of the lighting apparatus 100 (the B direction shown in FIG.1) according to the first embodiment of the present invention. FIG. 4 is a cross section diagram which shows the structure of the lighting apparatus 100 (the surface in the A direction shown in FIG. 1) according to the first embodiment of the present invention. FIG. 5 is a cross-section diagram which shows the structure of the lighting apparatus 100 for the C1-C2 surface shown by FIG. 3 and FIG. 4.

As shown in FIG. 1, FIG. 2 and FIG. 3, the lighting apparatus 100 includes the power source device 1 and the light-emitting unit 132. As shown in FIG. 4 and FIG. 5, the power source device 1 includes circuit parts and a board 40 inside. Additionally, the light-emitting unit 132 includes a casing unit 133, and inside the casing unit 133, solid-state light-emitting devices 134, a board 135 and a protective translucent board 136 are included.

As shown in FIG. 2, the power source device 1 is shaped like a chopstick box (i.e. a box that is small, slim, and rectangular in shape) and is composed of a socket 72 and a casing 71. The power source device 1 converts the AC power source into DC and provides the DC to the light-emitting unit 132.

The socket 72 is used so that the power source device 1 uses an AC power source such as a commercial AC power source, and connects the AC power source with the power source device 1.

The casing 71 is shaped like a chopstick box and has the shape shown in the exterior view of the power source device 1. Below for example the size of the casing 71 is the same size as the long, thin rectangular box. Additionally, the circuit parts which compose the power source device 1 are housed inside the casing 71. The casing 71 is composed of material with a high degree of heat conductivity (preferably greater than or equal to 200W/m·K). For example, the inventors have selected aluminum as a material with a high degree of heat conductivity and which is also quite processable, and have made the casing 71 using aluminum.

The light-emitting unit 132 causes a solid-state light-emitting device such as an interior LED to emit light using DC supplied from the power source device 1.

The cross-section of the casing unit 133 is formed approximately in a U-shape. The casing unit 133 is composed of metal with a high degree of heat conductivity (preferably, metal with a degree of heat conductivity greater than or equal to 200W·m⁻¹· K⁻¹). For example, the casing unit 133 is composed of aluminum. Reasons raised for using aluminum in the casing unit 133 include: that aluminum is low-priced, easy to shape, easily recyclable, the degree of heat conductivity is greater than or equal to 200W·m⁻¹· K⁻¹, that the heat radiation property is high.

Additionally, after the casing unit 133 is composed aluminum, it is ideal that the casing unit 133 be anodized. By anodizing the casing, the surface area increases and the heat radiation effect improves.

The protective translucent board 136 has translucency and is arranged along a light-emitting direction of the solid-state light-emitting device 134. The protective translucent board 136 is formed in a flat-board shape. By combining the casing unit 133 and the protective translucent board 136, the cross-section becomes an approximately square shape.

The protective translucent board 136 is formed by transparent glass or acrylic resin, polycarbonate and so on. A minute irregularity is formed unevenly on the front or back of the protective translucent board 136 due to the surfacing process. The surfacing process can for example be performed easily by utilizing a sandblasting method. The protective transparent board 136 protects the solid-state light-emitting device 134 and so on which is laid out inside in the lighting apparatus 100. Additionally, the protective translucent board 136 has the role of diffusing the light emitted from the solid-state light-emitting device 134. The light emitted from the solid-state light-emitting device 134 has a strong directivity and a tendency to be irradiated locally. The directivity of the light is weakened, and the light can be equally irradiated over a wide area by the protective translucent board 136, which is surfacing processed, and by diffusing the light emitted from the solid-state light-emitting device 134.

A hollow structure formed by the casing unit 133 and the protective transparent board 136 is laid out inside the board 135. The board 135 is formed on the surface opposite the protective translucent board 136 on the inside of the hollow structure. The board 135 is formed by metal with a high degree of heat transmissivity (ideally, metal with a degree of heat transmissivity greater than or equal to 200W·m⁻¹·K⁻¹). Ideally, the board 135 is composed of the same materials as the casing unit 133. For example, the board 135 is composed of aluminum.

The solid-state light-emitting devices 134 are laid out on the board 135. The solid-state light-emitting devices 134 are, for example, light-emitting diodes. The solid-state light-emitting devices 134 are high-powered light-emitting diodes with a power consumption of 1W per diode, and are surface-mounted light-emitting diodes. A high-powered light-emitting diode is ideal for use in a lighting apparatus with high light intensity. When using the lighting apparatus 100 for general lighting, the light color emitted from the used solid-state light-emitting device 134 is ideal for a daylight color, a daylight-white color, a white color, a warm white color, a light bulb color and so on. More specifically for example, the solid-state light-emitting devices 134 emit light in a daylight color, a daylight-white color, a white color, a warm white color or a light bulb color as defined in "color regions" 4.2 in "Chromaticity range" in JISZ9112 "Classification of Fluorescent Lamps by Chromaticity and Color Rendering Property".

Additionally, the solid-state light-emitting devices 134 may emit blue-colored light which is light with a peak wavelength from 380 to 500 nm. Blue is said to have the effect of suppressing psychological excitation. Thus, the lighting apparatus 100 which emits blue-colored light is ideal as a crime-prevention light.

Below, it is critical to note that the casing unit 133, the board 135 and the casing 71 are arranged in contact with each other. This is because by opening space between the casing unit 133 and the board 135 and the casing unit 133 and the casing 71, the heat conduction from the casing unit 133 to the board 135 and between the casing unit 133 and the casing 71 is hindered and an effective heat process cannot be performed since heat conduction is hindered. Thus, by building the casing unit 133, the board 135 and the casing 71 out of the same materials, the adhesion between the casing unit 133, the board 135 and the casing 71 is ideally improved. Further, press processing is preferably performed in order to improve the adhesion.

When the above press processing is performed, material with adherence is inserted between the casing unit 133 and the board 135, and between the casing unit 133 and the casing 71 (for example, glue or double-sided tape without backing, and so on) (not pictured), and the adherence of both pairs is ideally improved.

Note that when using double-sided tape, it is critical to select tape without backing. This is because the heat conductivity of the backing is low and the heat conduction from the casing unit 133 to the board 135 and the board 135 to the casing 71 is hindered.

Ideally, the board 135 is divided into boards. This is done in order to prevent the worsening of adherence between the casing unit 133 and the board unit 135 when the linear expansion coefficient between the casing unit 133 and the board 135 differs, and the temperature of the lighting apparatus 100 increases. By dividing the board 135, the length-wise length for one board 135 decreases. Thus, the amount of expansion for one board 135 decreases. Thus, since the difference between the expansion of the casing unit 133 and the board 135 is easier to extract using material with adherence, the adhesion of the casing unit 133 and the board 135 becomes easier to maintain. The method for dividing the board 135 is effective especially when the length-wise length of the lighting apparatus 100 is long.

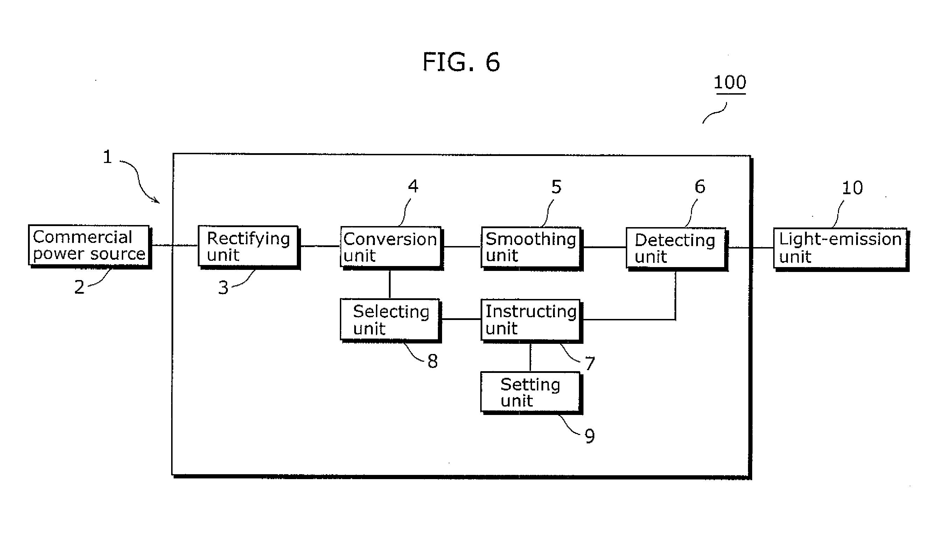

Next, the lighting apparatus 100 in the present invention is described more specifically using the drawings. FIG. 6 is a functional block diagram of the lighting apparatus 100 in the present invention.

The lighting apparatus 100 is a lighting apparatus which lights by using an AC power source to cause light-emitting devices to emit light, and includes a rectifying unit 3, a conversion unit 4, a smoothing unit 5, a detecting unit 6, an instructing unit 7, a selecting unit 8 and a setting unit 9.

The lighting apparatus 100 uses an AC power source supplied from a commercial power source 2, which is an external power source, to supply DC to the light-emitting unit 10 which is composed of single or plural solid-state light-emitting devices and causes the solid-state light-emitting devices to emit light.

The commercial power source 2 corresponds to an AC power source according to the present invention. More specifically, the commercial power source 2 is a power source provided to an average household or an office and so on from a power company, and provides AC to the lighting apparatus 100.

The rectifying unit 3 corresponds to an undulating voltage modification unit according to the present invention, and modifies a sine wave voltage of the power source into a pulsifying current. More specifically, the AC voltage supplied from the commercial power source 2 is fully rectified and the fully-rectified waveform is outputted to the conversion unit 4.

The conversion unit 4 corresponds to a switch unit and a transformer according to the present invention, and transforms the undulating voltage in which a duty cycle is controlled, the duty cycle being a ratio of ON time in which undulating voltage outputted from the undulating voltage modification unit is allowed to pass and OFF time in which the undulating voltage is not allowed to pass. More specifically, the fully -rectified waveform outputted from the rectifying unit 3 is divided by a predetermined time period and the voltage of the fully -rectified waveform divided into predetermined time periods is transformed into a pulse-shaped waveform for each time period in the above predetermined time periods. In other words, in the conversion unit 4, by controlling the duty cycle and sending the voltage of the fully-rectified waveform outputted from the rectifying unit 3 to a first side of the transformer included in the conversion unit 4, the voltage sent from the rectifying unit 3 for which the duty cycle is controlled is converted into voltage with a pulse-shaped waveform on the second side of the transformer included in the conversion unit 4. Additionally, the conversion unit 4 actualizes the above by being controlled by the selecting unit 8.

The smoothing unit 5 corresponds to the smoothing unit according to the present invention and smoothes the voltage transformed by the transformer. More specifically, the voltage in the pulse-shape waveform sent from the conversion unit 4 is smoothed, and supplied to the light-emitting unit 10 as DC.

The detecting unit 6 detects an operation point for the light-emitting unit 10 to which DC is supplied and which is powered by the power source device 1, and for example the temperature of a predetermined element in the conversion unit 4, the casing 71 in the transformer or the power source device 1. Thus, the operation point is calculated according to the vertical voltage product generated when current is allowed to pass through a solid-state light-emitting device in the light-emitting unit 10, in other words the product of (current) x (forward voltage).

The instructing unit 7 determines a target operation point (below, a target operation point) for the light-emitting unit 10 based on the operation point detected by the detecting unit 6, and the operation point which serves as a base set in advance by the setting unit 9 (below, a base operation point). The instructing unit 7 controls the selecting unit 8 to realize the target operation point.

The selecting unit 8 calculates the power load for the pulse-shaped waveform in each period in the predetermined time period above, which can realize the target operation point based on an instruction from the instructing unit 7. The selecting unit 8 controls the conversion unit 4 to realize the calculated power load.

The setting unit 9 sets the operation point which is the basis for the light-emitting unit 10.

Thus the base operation point for the light-emitting unit 10 in the setting unit 9 may be set for example by information being inputted into the setting unit 9 using a predetermined communication circuit such as infrared communication, wireless communication, wired communication and so on.

The light-emitting unit 10 corresponds to the light-emitting unit according to the present invention and causes the solid-state light-emitting devices to emit light. More specifically, a single or plural solid-state light-emitting devices are included. The light-emitting device is for example an LED.

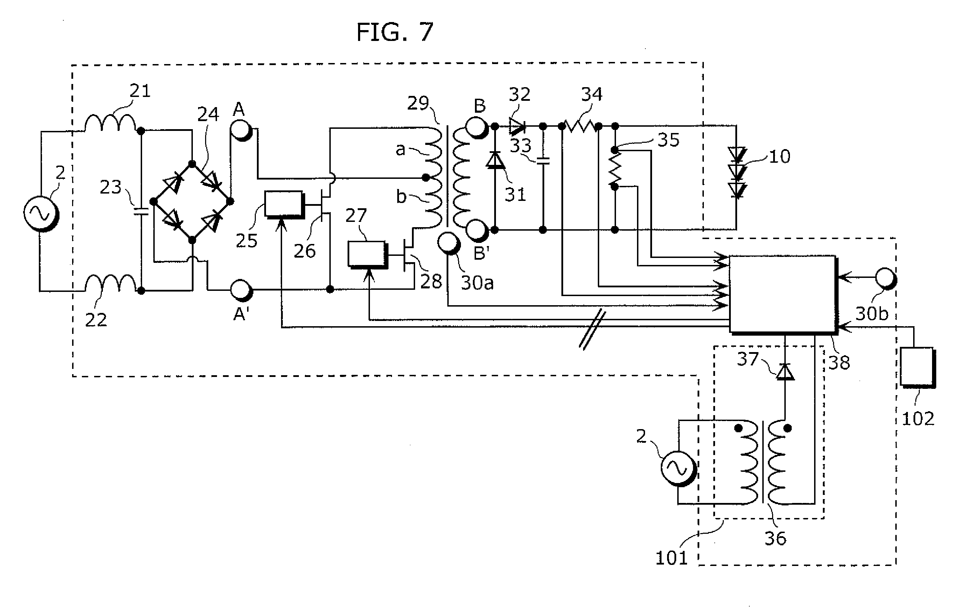

FIG. 7 is a diagram which shows a conceptual circuit structure of the lighting apparatus 100.

The lighting apparatus 100 shown in FIG. 6 can be realized by taking the structure of a conceptual circuit diagram as in FIG. 7.

The rectifying unit 3 is composed of an inductor 21, an inductor 22, a capacitor 23 and a diode bridge 24.

The inductor 21, the inductor 22 and the capacitor 23 are protective circuits which protect the lighting apparatus 100 from outside interference. Therefore, the capacitor 23 is not a smoothing capacitor.

A large capacity is needed for a smoothing capacitor. As a result, a normal electrolytic capacitor is utilized. However, as mentioned above, there are problems such as that of the size and lifespan of this type of capacitor.

The capacitor 23 is intended to protect the lighting apparatus 100 from outside interference as described above, and thus the capacity may be low. Thus, for example, a miniature capacitor with a long life span such as a ceramic capacitor is used.

The diode bridge 24 is a full-wave rectifier which fully rectifies AC waveform and outputs fully-rectified waveform.

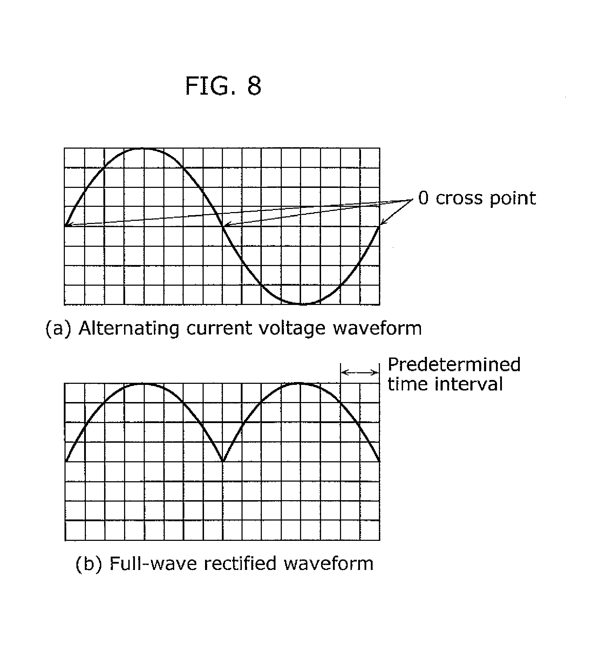

FIG. 8 is a diagram which describes the output waveform of the diode bridge which rectifies AC.

The diode bridge 24 rectifies an AC waveform such as that shown in FIG. 8(a), forms the fully-rectified waveform as shown in FIG. 8(b) and outputs the full-wave rectified waveform.

The conversion unit 4 is composed of a Field Effect Transistor (below, FET) 26, a FET 28, a transformer 29, a terminal pair A and A', which compose an input terminal pair, and a terminal pair B and B', which compose an output terminal pair. FET 26 and FET 28 function according to an instruction from the driver 25 and the driver 27 which compose the selecting unit 8, and when instructed to function, the terminal pair B and B', which is the output terminal pair of the transformer 29 in the conversion unit 4, generates an on-pulse. In other words, in the conversion unit 4, the voltage for the fully-rectified waveform outputted from the rectifying unit 3 is converted into voltage with a pulse-shaped waveform on the second side of the transformer included in the conversion unit 4 during the ON time, i.e. while being sent to the first side of the transformer included in the conversion unit 4, based on the controlled duty ratio.

Additionally, when the instruction is to not function, an off pulse is generated in the terminal pair B and B', which is the pair of output terminals in the transformer 29 in the conversion unit 4. In other words, during the OFF time in the conversion unit 4, i.e. while the voltage for the fully-rectified waveform outputted from the rectifying unit 3 based on the controlled duty ratio is not being sent to the first side of the transformer included in the conversion unit 4, the voltage is not converted as voltage on the second side of the transformer included in the conversion unit 4.

The smoothing unit 5 is composed of a diode 31, a diode 32 and a capacitor 33. The voltage with the pulse-shaped waveform from the terminal pair B and B' in the transformer 29 in the conversion unit 4 is smoothed by the circuit parts from the diode 31, the diode 32 and the capacitor 33. Accordingly, DC is supplied from the smoothing unit 5 to the light-emitting unit 10.

The detecting unit 6 is composed of a resistance 34, a resistance 35, a thermoelectric pair 30a, a thermoelectric pair 30b and a controller unit 38.

The detecting unit 6 can detect the electric current passed to the light-emitting unit 10 through the resistance 34 and can detect the forward voltage from the light-emitting unit 10 through the resistance 35. The current value and the voltage value information detected by the resistance 34 and the resistance 35 is sent to the controller unit 38.

The controller unit 38 finds an operation point from the information above. Below, the operation point as described above is a product of the current value detected by the resistance 34 and the forward voltage value detected by the resistance 35. An internal memory (not pictured) is included as a storage unit inside the controller unit 38.

The current value detected by the resistance 34, the forward voltage value detected by the resistance 35, and information about the operation points found based on the current value and the forward voltage value are stored and the information is held as history information in the internal memory.

The thermo-electric pair 30a detects the temperature of the transformer 29 in the conversion unit 4. The thermoelectric pair 30b detects the temperature of the casing 71. The temperature values detected respectively by the thermoelectric pair 30a and the thermoelectric pair 30b are sent to the controller unit 38, stored in the internal memory included inside the controller unit 38 (not pictured) and held.

The setting unit 9 is composed of the controller unit 38 and sets the base operation point of the light-emitting unit 10. Below, the controller unit 38 is connected to an outside-signal receiving apparatus or an outside input switch 102 outside of the lighting apparatus 100, and is for example connected to a remote control. Information according to the base operation point of the light-emitting unit 10 may be inputted by the external input switch 102 which is outside the lighting apparatus 100 by using the external signal receiving apparatus and the external input switch.

Additionally, when the external signal receiving apparatus is for example an infrared receiving apparatus, the base operation point of the light-emitting unit 10 can be controlled easily using infrared communication. In this way, there is the distinct effect in which light from the light-emitting unit 10 can be easily adjusted.

Additionally, information may be recorded in advance in the internal memory of the controller unit 38 (not pictured) such as the base operation point or a target operation point used for adjusting the light from the light-emitting unit 10. Further, the base operation point may be set in the setting unit 9 based on a temperature value of the casing 71 in the transformer 29 or the power source device 1 in the conversion unit 4 detected by the thermoelectric pair 30a and the thermoelectric pair 30b.

Information from the point when the lighting apparatus 100 is turned on until the voltage and the current are successively increased up to the base operation point including the current value detected by the resistance 34, the forward voltage value detected by the resistance 35 and the operation points based on the current value and the forward voltage value is stored and may be held in the internal memory of the controller unit 38 as history information. Here, the resistance 34 and the resistance 35 are controlled by the controller unit 38 in order to be detected per predetermined cycle.

Additionally, voltage and current applied by the lighting apparatus 100 may be determined based on history information held in the internal memory of the controller unit 38.

The instructing unit 7 is composed of the controller unit 38. The instructing unit 7 determines a target operation point based on the base operation point set by the setting unit 9 and the operation point detected and calculated by the detecting unit 6.

The selecting unit 8 is composed of a driver 25, a driver 27 and a controller unit 38.

The controller unit 38 instructs the driver 25 and the driver 27 to operate in order to realize the target operation point determined by the instructing unit 7. Subsequently, the driver 25 and the driver 27 control the operations of the FET 26 and the FET 28 based on the operation instruction from the controller unit 38.

Additionally, the power source device 1 further includes a power source unit 101 which converts AC to DC and supplies the DC to the controller unit 38. Thus, the power source unit 101 is insulated from the circuit part of the power source device 1 which supplies DC to the light-emitting unit 10.

The power source unit 101 is composed of a transformer 36 and a diode 37, which transform AC from the commercial power source 2 into DC using the transformer 36 and the diode 37, and supply DC to the controller unit 38. Thus, the transformer 29 and the transformer 36 are separate and independent.

Additionally, the operation instruction to the driver 25 and the driver 27 for realizing the target operation point determined by the instructing unit 7 is issued through the signal line connected to the controller unit 38, the driver 25 and the driver 27.

At the same time, the signal line which connects the controller unit 38, the driver 25 and the driver 27 is electrically insulated by using for example a photo coupler.

Thus the controller unit 38, the conversion unit 4 and so on are built to be electrically insulated. Thus for example, for example noise and so on generated in the conversion unit 4 and so on can be prevented from entering the controller unit 38. In this way, the controller unit 38 is protected from mistaken operations and the security of the power source device 1 improves. In other words, the reliability of the lighting apparatus 100 improves.

Thus, the microcomputer which corresponds to the controller unit 38 in the present productive apparatus for DC in the backlight device described in the above Patent Document 3 is not electrically insulated from the transistor which corresponds to the FET 26 and 28 in the present invention. Thus the microcomputer is endangered by the risk of a mistaken process due to noise and the like.

However, as described above, the lighting apparatus 100 in the present invention is electrically insulated from the controller unit 38, the conversion unit 4 and more specifically from the FET 26 and the FET 28, reducing the danger of a mistaken process due to noise and increases the reliability of the lighting apparatus 100.

Additionally, the transformer 29 in the conversion unit 4 has not only a function for simply converting the value of the voltage and the current to a desired value, but also a function for electrically insulating the terminal pair A and A', which is the input terminal pair, and the terminal pair B and B', which is an output pair in the conversion unit 4. Thus, the light-emitting unit 10 connected to the power source device 1 can be protected from noise from the commercial power source 2.

Further, the transformer 29 in the conversion unit 4 uses a center tap connection on a single-side of the coil.

Here, the "a" unit in the transformer 29 shown in FIG. 7 is between an end of the first coil and the center-tap in the transformer 29, and the "b" unit in the transformer 29 is between the other end of the first coil and the center-tap of the transformer 29.

The transformer 29 is composed such that the direction of magnetic flux generated by the "a" unit and the "b" unit is reversed. Thus, by making the "a" unit and the "b" unit operate successively, the transformer 29 can be prevented from unnecessarily magnetizing. Since this is linked to improving the durability of the power source device 1, the reliability of the power source device 1 increases.

However, the transformer used as a DC power source in the backlight device described in the above Patent Document 3 is not a type provided with a center-tap. Thus, it is predicted that long-term security will be in demand based on the long-life properties and so on of lamps loaded on a backlight device.

On the other hand, the lighting apparatus 100 in the present invention is an apparatus presumed to apply a high-powered LED as a 'solid-state light-emitting device' to the lighting apparatus as described above. The life of an LED is significantly long, and an LED can be used continuously for more than 10 years according to how it is used.

Given this, the power source device 1 in the present invention included in the lighting apparatus which includes the LED is required to have a design which is secure and can be used for more than 10 years. Accordingly, it is preferable to use a center tap connection which can realize secure processing over a long period for the transformer 29 in the conversion unit 4.

Additionally, the conversion unit 4 is controlled by the controller unit 38, the driver 25 and the driver 27 in the power source device 1.

Here, the controller unit 38 corresponds to the microcomputer unit according to the present invention and controls the duty cycle for the switch unit via the photo coupler. More specifically, the controller unit 38 is composed using the microcomputer, and implements control for generating a desired pulse-shaped waveform from the full-rectified waveform without converting the fully-rectified waveform inputted from the terminal pair A and A', which is the input terminal pair in the conversion unit 4, into DC.

Thus since there is no need to use a smoothing capacitor, the volume of the power source device 1 is largely reduced and its reliability can be improved. Below, the reason that the reliability can be improved is explained in detail.

In the constant current DC power source in the above Patent Document 2, the fully-rectified waveform is temporarily smoothed and in addition a pulse voltage wave with a particular character is obtained. In order to smooth the waveform, a large-capacity electrolytic capacitor is utilized. Shown more specifically, this corresponds to connecting the electrolytic capacitor to the terminal pair A and A', which are the input pair in the conversion unit 4. Since the volume of the electrolytic capacitor is large, it increases the size of the apparatus. Further, there is the problem that the capacity of the electrolytic capacitor is easily changed due to effects of the surrounding temperature. Additionally, there is the problem that the life of electric capacitor is short, as well as the problem of security. Thus, connecting the electrolytic capacitor invites the upsizing of the lighting apparatus and further, reduces the reliability of the lighting apparatus.

Although there is no need to use the electrolytic capacitor in the DC power source in the backlight device described in the Patent Document 3, there is a problem of security and stability as described above.

However, the problems of the power source device 1 in the present invention are completely solved and the present invention is ideal for the lighting apparatus which uses LED.

Next, the operations of the lighting apparatus 100 are explained using the diagrams.

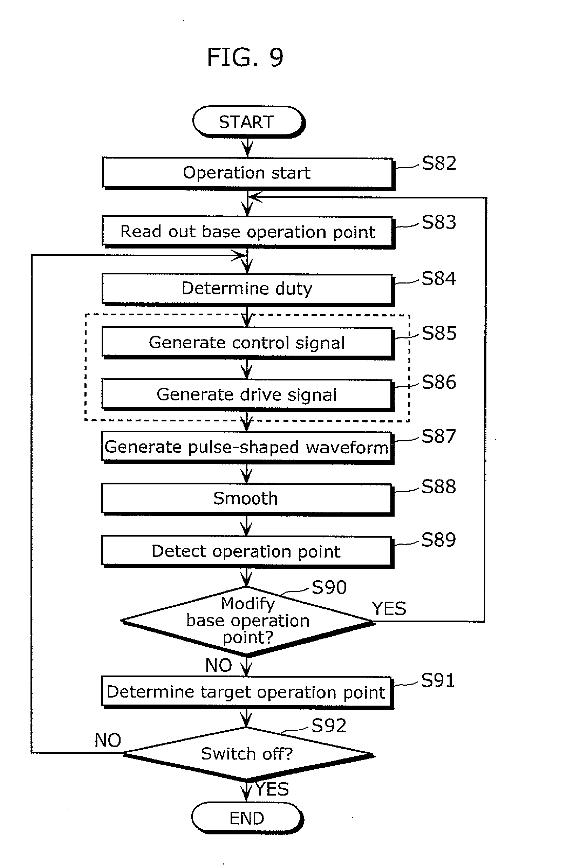

FIG. 9 is a flowchart which shows the functions of the lighting apparatus.

First, the power source 2 is turned on and power supply is begun to the electric source apparatus 1 in the lighting apparatus 100. Subsequently, the controller unit 38 begins operating (S82). Thus, after the commercial power source 2 has been turned on, the operations of the controller unit 38 have begun, however power is not supplied to the conversion unit 4 and the conversion unit 4 does not start up. The reason for selecting this method is to increase the security of the power source device 1. Due to starting up the controller unit 38 first, operations can be immediately stopped when there are problems with the power source device 1, the commercial power source 2 or the light-emitting unit 10. Additionally, another reason for selecting this method is that there is a need to detect the frequency of the commercial power source 2 before the conversion unit 4 begins operating. Within Japan, the frequency of the commercial power source 2 is 50 Hz for the east Japan region, and 60 Hz for the west Japan region. As mentioned above using the controller unit 38, in order to perform the desired control, the frequency of the commercial power source 2 must be detected. Here for example, the controller unit 38 controls starting supply of the AC to the conversion unit 4 using a switch and so on (not pictured).

Next, the instructing unit 7 reads out the base operation point from the setting unit 9 as the target operation point (S83).

Below, the operation point is a value found using a product of the current value run to the light-emitting unit 10 detected by the resistance 34, and the forward voltage value of the light-emitting unit 10 detected by the resistance 35. The operation point is measured in watts [W], which is equivalent to the power. The forward voltage of the light-emitting unit 10 is determined by the characteristics, number and so on of the solid-state light-emitting devices included in the light-emitting unit 10. Additionally, the forward voltage changes according to the temperature of the light-emitting unit 10 itself, which includes the solid-state light-emitting devices.

Additionally, since the light-emitting unit 10 which includes the solid-state light-emitting device is a current control element, the strength of light emitted from the light-emitting unit 10 is determined according to the value of the current run to the light--emitting unit 10. Accordingly, the basis operating point is determined from the forward voltage according to the characteristics and so on of the light-emitting unit 10 which is used, and from the current value according to the light intensity in the light-emitting unit 10. The light intensity of the light-emitting unit 10 is determined according to the strength of current run to the light-emitting unit 10 as described above. To put it another way, the light intensity of the light-emitting unit 10 changes freely by setting the value of the current run to the light-emitting unit 10, in other words the light can be adjusted.

Here, adjusting the light corresponds to modifying the base operation point of the light-emitting unit 10. Additionally, by modifying the base operation point of the light-emitting unit 10, the light intensity of the light-emitting unit 10 at this point can be strengthened (made brighter), and weakened (darkened).

Next, the selecting unit 8 determines and calculates the duty cycle for realizing the target operation point (S84). In other words, the selecting unit 8 determines the duty cycle of the voltage inputted to a single-side of the transformer 29 in the conversion unit 4 in order to realize the target operation point.

Next, control of the duty cycle determined by the selecting unit 8 is achieved by the conversion unit 4, and a signal for controlling the conversion unit 4 (control signal) is generated in the control unit 38 (S85).

Here, the voltage inputted into the conversion unit 4 is a fully-rectified waveform as shown in FIG. 8 (b). Using the voltage of the fully-rectified waveform shown in FIG. 8(b), the power necessary to realize the target operation point is generated.

Next, a drive signal for operating the FET 26 and the FET 28 is generated by the driver 25 and the driver 27 (S86). The drive signal is generated based on the control signal generated in S85. At this point, the driver 25 and the driver 27 check the content of the control signal.

Next, the FET 26 and the FET 28 are powered by the control signal generated in S85 and a pulse-shaped waveform is generated (S87).

Next, the smoothing unit 5 smoothes the voltage of the pulse-shaped waveform that is inputted, forms the voltage into a DC waveform and outputs the DC waveform (S88).

Next, the actual operation point of the light-emitting unit 10, in other words the product of the actual current value and the voltage value of the light-emitting unit 10 is detected by the detecting unit 6 (S89). The operation point of the light-emitting unit 10 fluctuates according to the temperature change and so on of the area temperature or the heat generation of the light-emitting unit 10. Thus, the actual operation point is checked and there is a need to correct it. Additionally, the temperature of the transformer 29 and the casing 71 is measured.

Next, it is confirmed whether or not there is a modification of the base operation point (S90). This corresponds for example to whether or not the user who uses the lighting apparatus 100 has modified the light intensity of the light-emitting unit 10.

Here, the period required by the detecting unit 6 to detect the operation point of the light-emitting unit 10 is ideally between 1[ms] to 500[ms]. Thus the operation point of the light-emitting unit 10 does not need to change steeply over time, and thus the period does not need to be set to a high speed. In other words there is no need for a real-time speed. Detection may be performed using an appropriate period or time interval. Thus the microcomputer loaded in the controller unit 38 (not pictured) has the distinct effect of being comparatively cheap and compact. In the experience of the inventors, a period of 150 [ms] is optimal.

When there is no modification to the base operation point (NO in S90), the instructing unit 7 compares the operation point detected in S89 and the base operation point, and sets the target operation point based on the result (S91). When there is a modification in the base operation point (YES in S90), the process moves to S83.

Note that when the detected operation point is within a predetermined operation range, the base operation point is ruled to have no modifications, and the detected operation point becomes the new target operation point.

Next, the instructing unit 7 confirms whether or not a stop signal is inputted from an outside input switch (not pictured) and the like (S92).

When a stop signal is inputted from the outside input switch (not pictured) and the like (YES in S92), the operations of the power source device 1 are stopped. This corresponds to for example the user using the lighting apparatus 100 turning off the light-emitting unit 10 in the lighting apparatus 100, in other words stopping the power supply to the power source device 1 in the lighting apparatus 100. At this point, the conversion unit 4 stops operations of the controller unit 38 before the predetermined time elapses. In other words, the controller unit 38 finishes the instruction to the conversion unit 4 within the time. Here, the predetermined time is ideally from 0.2[S] to 1[S].

The reason for selecting this method is to increase the security of the power source device 1 in the lighting apparatus 100. In other words, by stopping the controller unit 38 afterwards, when an error has generated in the power source device 1, the commercial power source 2 or the light-emitting unit 10, the error can be detected without being missed. Here for example, the controller unit 38 controls stopping supply of the AC power source in the conversion unit 4 using a switch and the like (not pictured).

Note that, when a stop signal is not inputted from an outside input switch (not pictured) and so on (NO in S92), the process returns to S84 and the above operation is repeated.

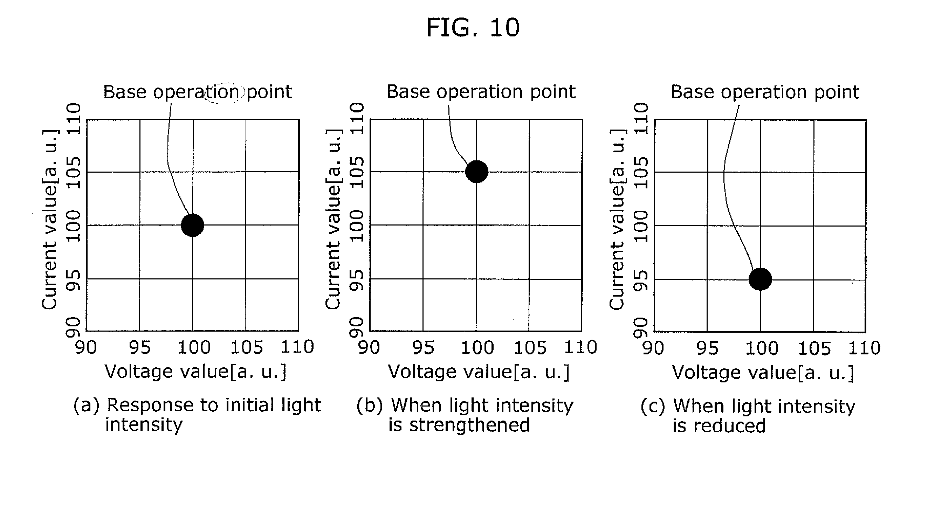

FIG. 10 is a diagram which explains modifying the light intensity by modifying the base operation point setting of the light-emitting unit 10. FIG. 10(a) shows the base operation point which indicates the light intensity at the (initial) point. When the light intensity of the light-emitting unit 10 is increased (brightened) in the initial period, the base operation point is moved and set as in FIG. 10(b). On the other hand, when the light intensity of the light-emitting unit 10 is decreased (darkened) in the initial period, the base operation point is moved and set as in FIG. 10(c).

Note that the setting of the base operation point may be performed via input from the outside input switch 102 which is connected to the setting unit 9, and may be performed by input from the outside signal receiving apparatus (not pictured) connected to the setting unit 9. In this way, the base operation point setting from the outside can be modified, in other words the light-emitting unit 10 can be adjusted from the outside.

Further, the base operation point may be set based on the temperature of the transformer 29 and the casing 71 detected by the thermoelectric pair 30a and the thermoelectric pair 30b. Thus, the security of power source device 1 can be improved. Below, the reason that the reliability can be improved is explained in detail. When the transformer 29 and the casing 71 have become abnormally high in temperature, there is a possibility that the power source device 1 will break down. Thus in order to prevent malfunction in the power source device 1, the temperature of the transformer 29 must be decreased. Thus the temperature of the transformer 29 can be decreased by setting the base operation point low. In other words, the voltage load from the commercial power source 2 connected to the transformer 29 can be decreased, and the temperature of the transformer 29 can be decreased by setting the base operation point low. For example, when the temperature of the transformer 29 is detected by the thermoelectric pair 30, and the detected temperature value of the transformer 29 exceeds the basis value (for example, 80 degrees), the temperature of the transformer 29 is reduced by reducing the base operation point.

Additionally, when the transformer 29 becomes abnormally high in temperature, the functions of the power source device 1 may be stopped. However when the reason for the transformer 29 becoming abnormally high in temperature is a disaster such as a fire, the operations of the power source device 1 are stopped, light emission from the light-emitting unit 10 is stopped and the area becomes dark. For this reason people in the vicinity may panic. Thus when the transformer 29 becomes abnormally high in temperature, light emission from the light-emitting unit 10 is ideally continued by operating the power source device 1 at a low base operation point.

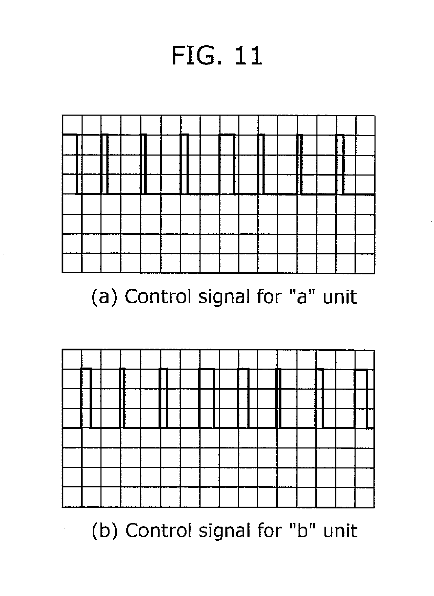

FIG. 11 is a diagram which describes the creation of a control signal by which the controller unit 38 controls the duty cycle of the conversion unit 4. The control signal shown in FIG. 11 is generated based on the output waveform (FIG. 8) of the diode bridge which rectifies the AC. Below, the creation of the control signal is explained in detail.

The voltage inputted into the conversion unit 4 is a fully-rectified waveform as shown in FIG. 8(b). Using the voltage in the fully-rectified waveform shown in FIG. 8(b), the power necessary to realize the target operation point is generated. For that reason a method like the one below is used.

First, as shown in FIG. 8(a), a 0 cross point in the AC voltage is detected in the commercial power source 2. Here, detecting the 0 cross point is performed each time the voltage wave form of the AC supplied from the commercial power source 2 crosses 0. This is because there are times when a subtle frequency change occurs in the voltage waveform of the AC supplied from the commercial power source 2; this subtle frequency change worsens the accuracy of control for the conversion unit 4. In order to prevent a deterioration in control accuracy in the conversion unit 4, the cross point is detected each time the AC voltage waveform passes the 0 cross point.

Next, the fully-rectified waveform is divided into predetermined time intervals with the 0 cross point as a base point, as in FIG. 8(b). Here, the time interval is set such that the area from one base point to the next base point is divided into 4 regions, and the present invention is not limited to this amount of regions. Incidentally, the time interval is set to from 2[µs] to 20[µs] in order to ease the smoothing of the smoothing unit 5. In the experience of the inventors, 4[µs] is optimal.

Next, the power necessary for each region is realized. Here, the power is the product of the voltage and the current as described above. For this reason, a signal for controlling the conversion unit 4 is generated in the controller unit 38 in order to modify the duty cycle for obtaining the power necessary for each region.

The transformer 29 uses a center tap connection on single-side of the coil. Thus, two control signals, one for the "a" unit and one for the "b" unit on the first coil side of the transformer 29 must be generated, as in FIG. 11(a) and FIG. 11(b).

Note that the control signal for the "a" unit on the first coil side of the transformer 29 and the control signal for the "b" unit on the first coil side of the transformer 29 do not simultaneously become "Hi" (in other words, the FET 26 and the FET 28 operate simultaneously). In the rare case that the control signals become Hi simultaneously, the transformer 29 malfunctions.

Accordingly, the control signal for the "a" unit on the first coil side of the transformer 29 and the control signal for the "b" unit on the first coil side of the transformer 29 do not exceed 50% of the set region and do not become "Hi" together. Further, in consideration of security, the inventors did not allow the units to exceed 49% in the set region and become Hi. More specifically, the driver 25 and the driver 27 are checked to see whether the "a" unit control signal and the "b" unit control signal have become "Hi" simultaneously. When the control signals are simultaneously "Hi", the "b" unit control signal is modified to "Lo" and a drive signal is generated.

Additionally, after the frequency of the commercial power source 2 is detected (S82) and a 0 cross point is detected, the 0 cross point becomes a base point and ideally a time at which the next 0 cross point is detected is calculated in advance.

By calculating in this way, the control signal is forced to "Lo" before the next 0 cross point is detected, and the operations of the conversion unit 4 can be stopped. Since this is linked to preventing mistaken operations in the power source device 1, the reliability of the power source device 1 can be increased.

In addition, when the necessary power for realizing the target operation point generated by the conversion unit 4 is significantly low, the time in which the control signal becomes "Hi" is significantly decreased. As a result, generating power in the set region is difficult.

For example, compared to a 100W lighting apparatus 100, when the power supplied to the lighting apparatus 100 is several Watts directly after the lighting apparatus 100 begins to light, the duty cycle is controlled in order to generate power at several Watts, the ON time in which voltage is allowed to pass from the commercial power source 2 to the conversion unit 4 becomes significantly low. The ON time, in which voltage is allowed to pass from the commercial power source 2 to the conversion unit 4 during duty cycle control correlates with the time in which the above control signal becomes "Hi".

One strategy for increasing the time in which the control signal becomes "Hi" is performed as described below. Note that the time interval is set such that the area from one base point to the next base point is divided into 4 regions.

First, a control signal is generated (the control signals for unit "a" and unit "b" are generated together) according to power which corresponds to twice the necessary power which must be generated in the conversion unit 4 in the first region from the base point (0 cross point). Thus the time in which the control signal in the region becomes "Hi" can be increased. On the other hand, in the second region from the base point, the control signal is maintained at "Lo" (the control signals for unit "a" and unit "b" are maintained at "Lo").

In the second region, the control signal is maintained at "Lo" during a third period from the base point. In the fourth region from the base point, a control signal according to the power, corresponding to twice the necessary power which must be generated in the conversion unit 4, is generated (the control signals for the unit "a" and the unit "b" are generated together). Thus the time in which the control signal in the region becomes "Hi" can be increased.

Below, the first and second periods are successively repeated. By doing so, from the time when the power generated in the conversion unit 4 is significantly low to when the target operation point is realized, the operation security of the power source device 1 is not affected and control can be performed.

Here, the above is performed with four regions, however the number of regions is not limited to this. The above method may be performed according to the number of regions without changing the intent of the invention, using appropriate modifications.

Additionally the unit "a" and the unit "b" in the transformer 29 of the conversion unit 4 are ideally used with ideal equality. This is because when only one unit is used quite often, the transformer 29 is unnecessarily magnetized. In order to prevent unnecessary magnetization, the unit "a" and the unit "b" must be used with extreme equality.

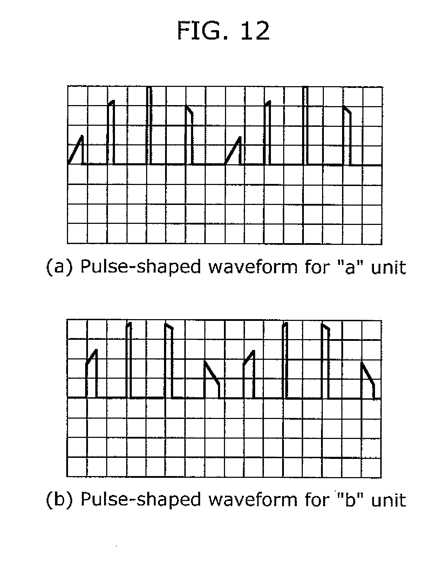

FIG. 12 is a diagram which shows the pulse-shaped waveform which powers the FET 26 and the FET 28 based on the control signal in FIG. 11 and in which the results are obtained.

The pulse-shaped waveform (FIG. 12(a) and FIG. 12(b)) is generated by powering the FET 26 and the FET 28 using the control signal which has been generated (FIG. 11(a) and FIG. 11(b)).

FIG. 13 is a diagram which describes the target operation point when the operation point actually detected for the light-emitting unit 10 diverges from the predetermined operation range from the base operation point.

FIG. 13(a) is a figure which shows the response when for example the operation point detected at S89 has moved to the top left of the figure, in other words when the operation point is outside the upper limit range of the predetermined operation range. This corresponds to when the forward voltage of the light-emitting unit 10 decreases due to the increase in the vicinity temperature and so on and the current increases to the same extent. In this case, the light-emitting unit 10 emits light stronger (brighter) than the desired light intensity. As a result, the control operation point is determined and this point is used as the new target operation point. In this way, the operation points fit within the predetermined operation range (a range of 95 to 105 when the current run to the light-emitting unit 10 has a current value of 100 based on the base operation point, in other words when the predetermined operation range is a range of ±5%).

Note that even when the predetermined operation range is not a range of ±5%, the range may be expanded to ±10%. However, to the extent that the range is widened, changes in the light intensity of the light-emitting unit 10 increase, and since this makes people in the vicinity uncomfortable, an appropriate range must be set. In the tests of the inventors, when the above range is ±5% and there is no discomfort, the value is used.

FIG. 13(b) is a figure which shows the response when for example the operation point detected at S89 has moved to the bottom right of the figure, in other words when the operation point diverges outside the lower limit range of the predetermined operation range. In the same way as FIG. 13(a), the control operation point is determined and used as the target operation point.

Note that by modifying the duty cycle based on the temperature of the transformer 29 or the casing 71 detected by the thermoelectric pair 30a and the thermoelectric pair 30b in the detecting unit 6, the temperature of the transformer 29 or the casing 71 may be adjusted. Below, the sequence is explained.

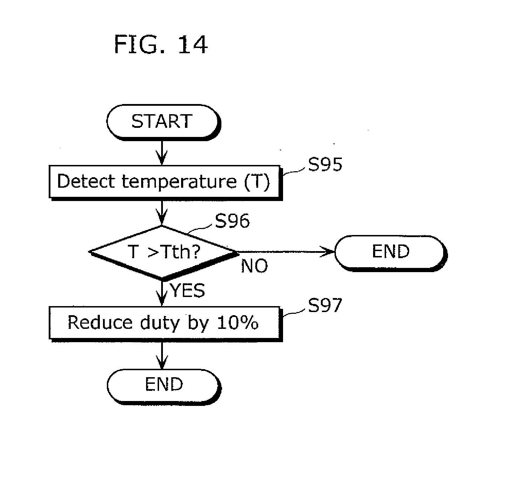

FIG. 14 is a flow chart which shows the sequence in which the duty cycle is modified based on the temperature detected by the detecting unit 6.

First, the temperature (T) is detected by the detecting unit 6. More specifically, the temperature of the transformer 29 or the casing 71 is detected by the thermoelectric pair 30a and the thermoelectric pair 30b in the detecting unit 6 (S95).

Next, it is confirmed whether or not the temperature (T) detected by the detecting unit 6 exceeds a threshold value of the temperature (Tth) determined beforehand. More specifically, it is determined whether the temperature of the transformer 29 or the casing 71 detected by the thermoelectric pair 30a and the thermoelectric pair 30b in the detecting unit 6 exceeds the temperature threshold value determined beforehand as an upper-limit value which can be operated securely.

Next, when the temperature (T) detected by the detecting unit 6 exceeds the threshold value of the temperature (Tth) determined beforehand (YES in S96), the ON time of the duty cycle for the conversion unit 44 is decreased by 10% (in effect, reducing the base operation point). In other words the voltage generated in the transformer 29 in the conversion unit 4 (current) can be suppressed, and the heat which is generated in the transformer 29 or the voltage or current applied to the solid-state device in the light-emitting unit 10 is suppressed. Thus, the transformer 29 or the casing 71 can be powered at a temperature lower than the threshold temperature value (Tth) determined in advance.

Note that when the temperature (T) detected by the detecting unit 6 is lower than the threshold value of the temperature (Tth) determined beforehand (NO in S96), there is no need to modify the duty cycle and thus the operation is temporarily ended.

In this way, by detecting the temperature (T) using the detecting unit 6 in the predetermined period, the lighting apparatus 100 can be safely powered in the temperature range.

By modifying the duty cycle based on the operation point which is the product of the current value and the forward voltage value detected by the resistance 34 and the resistance 35 in the detecting unit 6, the base operation point may be adjusted. Below, the operations performed by the lighting apparatus, when the base operation point is modified, is explained.

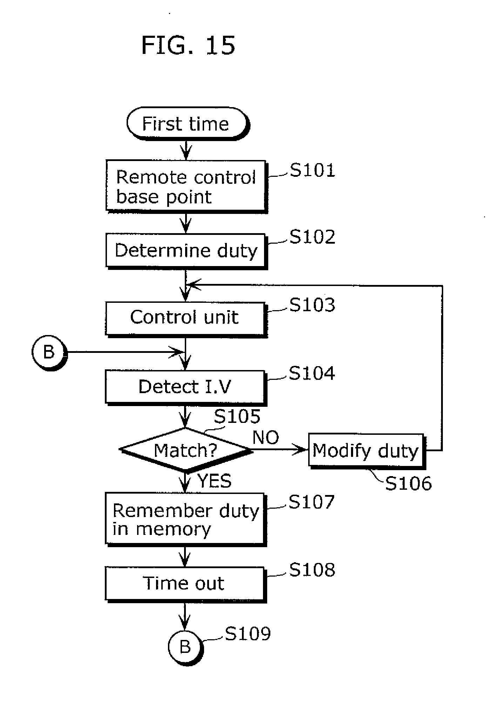

FIG. 15 is a flowchart which shows the operation performed by the lighting apparatus 100 when the base operation point of the lighting apparatus 100 is modified.

First, outside of the lighting apparatus 100, the base point (the base operation point) is modified (S101) for the lighting apparatus 100 through the external signal receiving apparatus or the external input switch 102 connected to the lighting apparatus 100, for example a remote control. This corresponds to the strengthening (brightening), and the reduction (darkening) of the light intensity of the lighting apparatus 100. For example, the light intensity of the lighting apparatus 100 is presently 100W and corresponds to reduction of the light intensity of the lighting apparatus 100 by setting the base point at 80W.

Next, in order to realize the base point (the base operation point) modified through the remote control, the lighting apparatus 100 determines the duty cycle for the conversion unit 4 (S102).

Next, the lighting apparatus 100 controls the conversion unit 4 (5103) in order to realize the duty cycle determined in S102.

Next, the lighting apparatus 100 detects the current run to the light-emitting unit 10 through the resistance 34 in the detecting unit 6, and detects the forward voltage of the light-emitting unit 10 through the resistance 35 in the detecting unit 6. Subsequently, a current value calculated by the resistance 34, a forward voltage value detected through the resistance 35, and an operation point are calculated based on these values (S104).

Next, the lighting apparatus 100 confirms whether or not the calculated operation point matches with the modified base point (the base operation point) through the remote control (S105).

Next, when the calculated operation point and the base point (base operation point) modified via the remote control match (YES in S105), the current value detected by the resistance 34 in the detection unit 6, the forward voltage value detected by the resistance 35 in the detection unit 6, and history information regarding the operation points found based on the above are recorded and held in the internal memory of the controller unit 38 as history information.

Next, after the fixed time has elapsed (displayed as 'time out' in the figure), the lighting apparatus 100 again detects the current run to the light-emitting unit 10 through the resistance 34 in the detecting unit 6 and detects the forward voltage of the light-emitting unit 10 through the resistance 35 in the detecting unit 6. Subsequently, a current value detected by the resistance 34, a forward voltage value detected through the resistance 35, and an operation point are calculated based on these values.

Here, after the fixed time has elapsed, the reason for the lighting apparatus 100 again detecting the current run to the light-emitting unit 10 through the resistance 34 in the detecting unit 6 is because the state of the light-emitting unit 10 in the lighting apparatus 100 changes due to environmental change, such as a change in the temperature of the vicinity, it is confirmed whether or not the operation point deviates from the predetermined operation range as shown in FIG. 13.

Note that when the calculated operation point and the base point (base operation point) modified via the remote control do not match (NO in S105), the lighting apparatus 100 modifies the duty cycle determined for the conversion unit 4 and executes the S103 process once again. Here for example the modified duty cycle is 10%.

Note that directly after power to the lighting apparatus 100 is turned on, an operation may be performed with applies the applied voltage and current successively up to the base operation point. In this case, the base operation point determined beforehand is only a remote control base point at S101, as are the other base operation points.

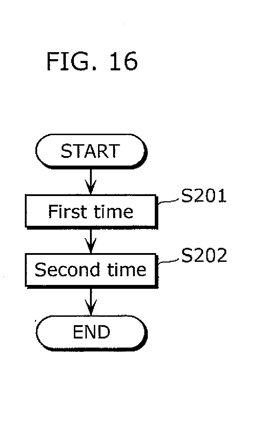

FIG. 16 is a flowchart which shows a process performed by a number of processes after modification of the base operation point for the lighting apparatus 100.

First, it is confirmed whether or not the process after the modification of the base operation point for the lighting apparatus 100 is the first process (S201). When the process is the first process, the process is started from S101 in FIG. 15.

Next, it is confirmed whether or not the process after the modification of the base operation point for the lighting apparatus 100 is subsequent to the second process (S202). When it is subsequent to the second process, the process is started from S103 in FIG. 15.

At this time, the duty cycle as well as voltage and current applied to the lighting apparatus 100 are determined based on history information held in the internal memory of the controller unit 38 in the lighting apparatus 100.

As above, the lighting apparatus 100 in the present invention may not use a smoothing capacitor in circuit parts which compose the power source device 1 in the lighting apparatus 100. As a result, the power source device 1 can be miniaturized. Although essential in conventional power source devices, significant miniaturization can be achieved by simply realizing a power source device which does not use a smoothing capacitor with a large volume. However, the LED used in the light-emitting unit 10 in the lighting apparatus 100 is significantly smaller compared to a fluorescent lamp and the like, and by selecting an arbitrary number of LEDs, the size of the light-emitting unit 10 can be designed arbitrarily. For that reason, a further miniaturization is required to the extent that the power source device 1 in the lighting apparatus 100 is miniaturized.

Here, a method is described below for adequately reducing the size of the casing 71 in the power source device 1 by optimally laying out the circuit parts which compose the power source device 1 and mounting the circuit parts on the board with high accuracy.

The power source device 1 includes the casing 71 and the socket 72 as shown in FIG. 2. As shown in FIG. 4, a board 40 on which circuit parts which compose the power source device 1 is housed inside the casing 71 in the power source device 1.

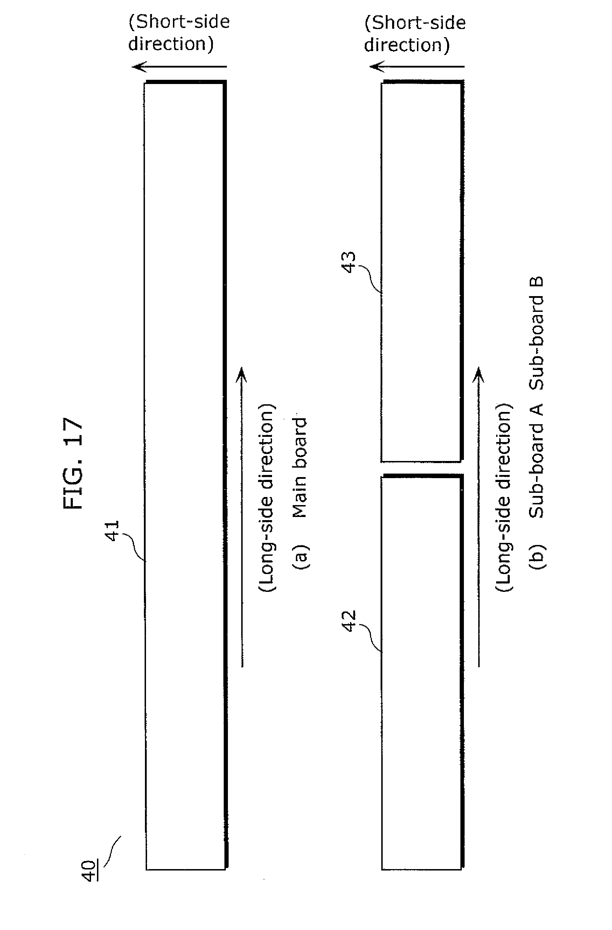

FIG. 17 is a diagram which shows a conceptual structure of the board 40 included in the power source device 1. The board 40 which is housed in the casing 71 of the power source device 1 is a pre-mounted board on which circuit parts are mounted, and is made up of a main board 41 shown in FIG. 17(a), a sub-board 42 and a sub-board 43. Here, the number of sub-boards is not limited and of course may be set at discretion.

The main board 41 is a rectangle shape. FIG. 17(a) is a diagram seen from the direction of the mounting surface of the main board 41. In the same way, the sub-board 42 and the sub-board 43 are rectangular shapes. FIG. 17(b) is a diagram seen from the direction of the mounting surface of the main board 41.

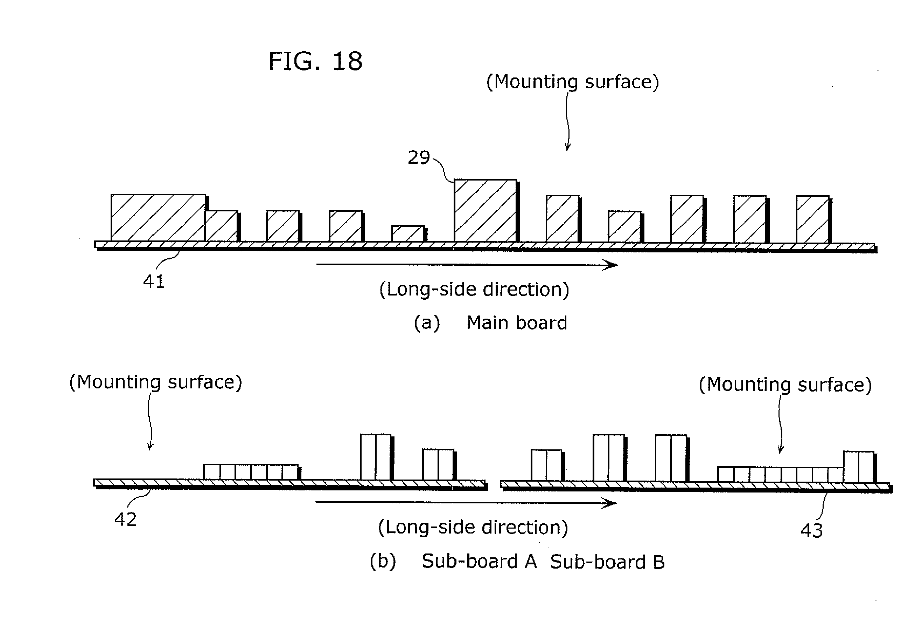

FIG. 18 is a diagram illustrating when various types of circuit parts are mounted on the board 40 included in the power source device 1. In FIG. 18, circuit parts included in the power source device 1 of the lighting apparatus 100 shown in FIG. 7 such as the transformer 29 are mounted on the main board 41, the sub-board 42 and the sub-board 43.

FIG. 18(a) is a diagram seen from the direction of the mounting surface of the main board 41. In FIG. 18(a), the hatching-etched portions show various types of circuit parts included in the power source device 1, and the main board 41 on which various types of circuit parts are mounted which compose the power source device 1 is shown.

On the other hand, FIG. 18(b) is a diagram in which the sub-board 42 and the sub-board 43 are seen from the direction which is the mounting surface. FIG. 18(b) show various types of circuit parts included in the power source device 1, and the sub-board 42 and the sub-board 43 on which various types of circuit parts are mounted which compose the power source device 1 are shown.

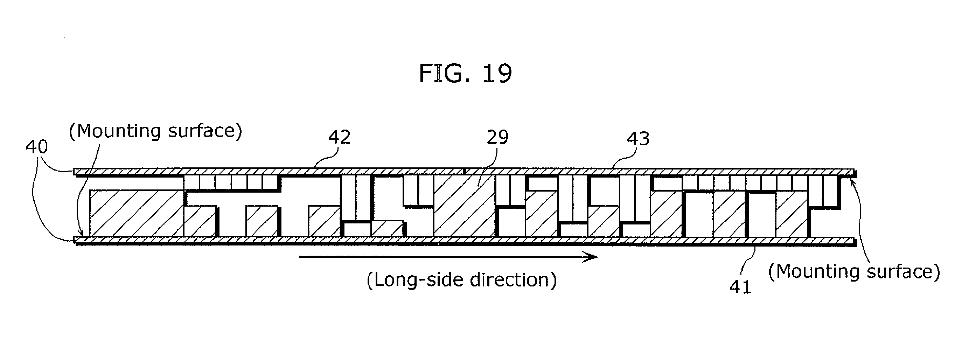

FIG. 19 is a diagram which shows that the main board 41 is laid out facing the respective mounting surfaces of the sub-board 42 and the sub-board 43. FIG. 19 shows that the mounting surface of the main board 41 on which various types of circuit parts are mounted as shown in FIG. 18(a) is arranged along length-wise direction facing mounting surface of the sub-board 42 and mounting surface of the sub-board 43 on which various types of circuit parts are mounted as shown in FIG. 18(b). Below, the essential point is that the various mounted types of circuit parts do not interfere with each other when the sub-board 42 and the sub-board 43 are laid out facing the main board 41 as shown in FIG. 19.

Accordingly, the distance between the mounting surface of the main board 41 and the mounting surfaces of the sub-board 42 and the sub-board 43 is roughly the same as the tallest circuit part (here, the transformer 29) for each type of circuit part mounted on the main board 41, the sub-board 42 and the sub-board 43.

When the mounting surfaces of the sub-board 42 and the sub-board 43 are arranged facing the main board 41, it is essential that the sub-board 42 and the sub-board 43 do not protrude from the main board 41 and are completely mounted. Thus the power source device 1 can be reduced to a minimum volume, in other words an adequate miniaturization can be achieved.

Thus the power source device 1 as shown above is presumed to apply to the lighting apparatus which uses a solid-state light-emitting device (here, an LED). Each LED is significantly miniature and thus a lighting apparatus which uses a conventional fluorescent lamp and so on and which could not be realized in the lighting apparatus and a miniature and well-designed lighting apparatus can be realized by utilizing LEDs. Thus the power source device 1 must be miniaturized as much as possible, and must be easily incorporated into the lighting apparatus 100. Thus a remarkably reduced volume ratio can be realized for the power source device 100 in the power source device 1 included in the lighting apparatus 100.

Incidentally, miniaturization for the DC power source in the backlight device described in the above Patent Document 3 is not described above. Thus application to the lighting apparatus which uses LED cannot be achieved with a DC power source in the backlight device in the above Patent Document 3.

Here, by executing a computer readable and executable program, a mounting position in the circuit parts such as the transformer 29 for the main board 41, the sub-board 42 and the sub-board 43, and so on is determined based on the size of the circuit parts such as the main board 41, the sub-board 42, the sub-board 43 and the transformer 29 used by the power source device 1.

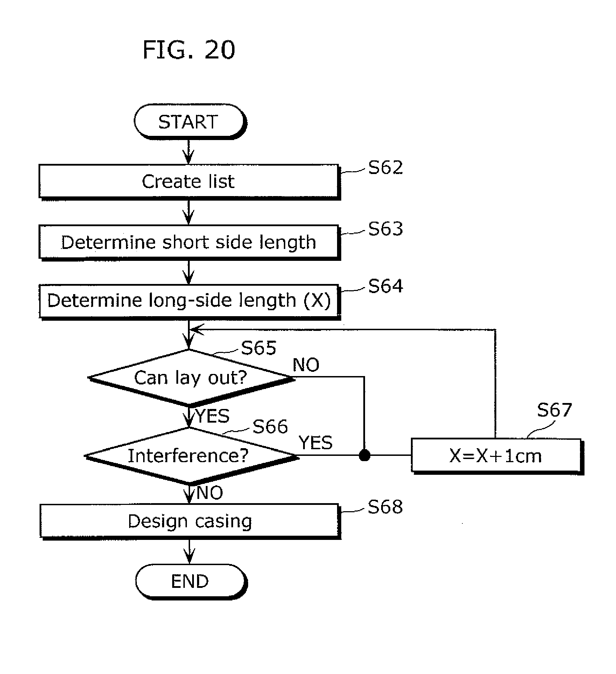

FIG. 20 is a flowchart which shows a sequence for minimizing the size of the board 40 included in the power source device 1.

First, a list of the various types of circuit parts included in the power source device 1 is generated. Here, the various types of circuit parts are selected based on the DC power value which the power source device 1 should output in a specification that is determined in advance (S62). Additionally, the tallest circuit part and the widest circuit part are extracted from the list of the various circuit parts generated in S62.

Here, for example, the tallest circuit part and the widest circuit part in the various circuit parts which compose the power source device 1 is the transformer 29.

Next, the short side lengths of the main board 41, the sub-board 42 and the sub-board 43 are determined. It is determined that the lengths of the widest circuit part among the various circuit parts which compose the power source device 1, the short side length of the main board 41, the sub-board 42 and the sub-board 43 should be equal (S63).

Here for example, since the tallest circuit part and the widest circuit part among the various circuit parts which compose the power source device 1 is the transformer 29 and thus the width of the transformer 29, it is determined that the short side lengths of the main board 41, the sub-board 42 and the sub-board 43 must be equal.

Next, the long side length of the main board 41 (X) is determined to be twice the length of the short side length determined in S63 (S64). Additionally, the length of the long side of the sub-board 42 and the sub-board 43 is determined to be 1/2 the length of the main board 41 (X/2). In other words, the length of the long side of the main board 41 (X) is determined to be equal to the length when the long side of the sub-board 42 and the long side of the sub-board 43 are added together.

Next, it is confirmed whether or not all of the various circuit parts (for example transformer 29, controller unit 38 and so on) shown in FIG. 7 can be laid out on-board the sub-board 42 and the sub-board 43.

Next, when all of the various circuit parts (for example the transformer 29, the controller unit 38 and so on) shown in FIG. 7 can be laid out on-board the main board 41, the sub-board 42 and the sub-board 43 (YES in S65), it is confirmed whether or not the circuit parts mounted on the sub-board 42 and the sub-board 43 interfere with each other when the mounting surfaces of the sub-board 42 and the sub-board 43 are mounted facing the mounting surface of the main board 41. More specifically, it is confirmed whether the height of the tallest circuit part among the various circuit parts which compose the power source device 1 matches the distance between the main board 41 and the sub-board 42 and the sub-board 43 when the mounting surfaces of the sub-board 42 and the sub-board 43 are mounted facing the main board 41.

Next, when no interference is generated between circuit parts mounted on the main board 41, the sub-board 42 and the sub-board 43 (NO in S66), the size of the casing 71 which is the lowest possible limit within which the main board 41, the sub-board 42 and the sub-board 43, which are used as various circuit parts in the power source device 1, can be housed (S68).

Here the casing 71 is ideally made up of material with a high heat conductivity (ideally more than 200W/m·K). For example, the inventors built the casing 71 using aluminum, which has a high heat conductivity and is easily processed.

Note that when the various circuit parts (for example transformer 29, controller unit 38 and so on) shown in FIG. 7 cannot be laid out on-board the main board 41, the sub-board 42 and the sub-board 43 (NO in S65), or when interference is generated between the circuit parts mounted on the main board 41, the sub-board 42 and the sub-board 43 (NO in S66), the length of the long side of the main board 41 is increased by a predetermined amount (S67). More specifically, before executing S67 in which a value of 1cm is added to the length of the long side X of the main board 41, and thus X+1cm becomes the length of the long side of the main board 41. Additionally, before executing S67 in which the value in which 1cm is added to the length of the X direction of the main board 41 (X+1cm) is halved, and determined to be (X+1)/2cm for the long side length of the sub-board 42 and the sub-board 43. Subsequently, it is confirmed whether or not all of the various circuit parts (for example transformer 29, controller unit 38 and so on) shown in FIG. 7 can be laid out on-board the sub-board 42 and the sub-board 43, and the sequence of S65 and S66 repeats until interference between the circuit parts mounted on the main board 41, the sub-board 42 and the sub-board 43 stops.

It follows from the above that the power source device 1 can be designed at a minimum size. The power source device 1 designed in this way includes circuit parts which compose the power source device 1 and can achieve a minimum width, height and size. Accordingly, the power source device 1 is condensed for compactness and is an adequately miniaturized power source device.

The power source device 1 in the present invention is presumed to be applicable to a solid-state light-emitting device (LED). LEDs are small elements and thus ideal for inclusion in an independent and adequately miniaturized lighting apparatus. However when the power source device which is the powering source that powers the LED-using light--emitting unit 10 is large, the characteristics of the LED are not adequately realized.

For example, a DC power source in the backlight device in the above Patent Document 3 is not conceived in relation to the size of the unit. As a result, since a part of the power source device is not adequately miniaturized, the size of the power source becomes an obstacle and a miniaturized lighting apparatus 100 which uses LEDs cannot be realized.

On the other hand, since the necessary circuit parts for the power source device 1 are mounted compactly, the power source device 1 in the present invention is significantly compact and ideal for achieving an LED-using miniature lighting apparatus 100. Thus the value in productivity is large.

The size of the power source device 1 shown in FIG. 2 is determined based on the design above, various circuit parts are mounted and the compacted mounting board housed in the casing 71 is shown. FIG. 4 shows the main board 41, the sub-board 42 and the sub-board 43 which compose the power source device 1 housed in the casing 71 when the mounting surfaces of the sub-board 42 and the sub-board 43 are mounted facing the mounting surface of the main board 41.

Here, the reason the casing 71 is built with high heat conductivity is to offset heat radiation. The power source device 1 which the inventors have created has a maximum input power of 105W, a maximum output power of 100W and an efficiency of approximately 95%. Accordingly, 5W is lost and the loss becomes heat.

As described above, the power source device 1 is presumed to apply to the lighting apparatus which uses solid-state light-emitting devices (LEDs). In order to use the LED-using lighting apparatus 100 securely for a long period, for example more than 10 years, the heat generated as loss in the power source device 1 and the light-emitting unit 10 must be appropriately processed in the lighting apparatus 100. When heat is appropriately processed, deterioration in the circuit parts of the power source device 1 can be prevented and long-term secure use can be assured.

Thus the heat radiation properties of the power source device 1 must be improved by building the casing 71 with highly heat conductive materials.

Additionally, when the casing 71 is built with aluminum, the aluminum should ideally be anodized. In this way the surface area of the casing 71 can be increased and heat radiation in the power source device 1 can be improved.

As above, the power source device 1 in the present invention is optimized to be applicable to the lighting apparatus 100 which uses a solid-state light-emitting device (LED).

However the LED portions of the LED-using lighting apparatus 100 can be maintenance free for more than 10 years depending on the usage method. Thus it is hoped that the lighting apparatus can be used securely for more than ten years. The lighting apparatus 100 in the present invention is designed such that security is increased. Therefore, depending on the usage method, long-term reliability which includes use of for example 10 years or more without maintenance can be obtained. Additionally, by optimally laying out the circuit parts which compose the power source device 1 and housing a densely mounted board at the smallest size in the casing 71, a compact power source device 1 can be achieved. Therefore, another feature of the LED is that the LEDs are optimized to achieve miniaturization and a variable shape for the lighting apparatus.

Note that the densely mounted board housed in the casing 71 of the power source device 1 is ideally a board mounted on only a single side, however the board may be mounted on both sides as well. The dual-mounted board described here includes the case where circuit parts of the power source device 1 are mounted equally on both sides of a dual-sided mounting board, and the case where critical circuit parts are mounted with high density on a single side of the mounting board, and other circuit parts are mounted on the other side of the mounting board.

Additionally, an insulating resin may be inserted in the highly dense mounted boards facing each other, which are housed in the casing 71 of the power source device 1. Thus insulation between the circuit parts can be improved and the reliability of the power source device 1 can be improved.

Additionally, the power source device 1 may modify the operation point of the light-emitting unit 10 using infrared, in other words the power source device 1 may adjust the light. For example, an infrared remote (not pictured) is used. With the infrared remote, the lighting apparatus 100 can be adjusted independently from a position away from the lighting apparatus 100.

Additionally, the casing 71 of the power source device 1 and the casing unit 133 of the light-emitting unit 10 may be formed of the same material as the board 135 (here, aluminum) and combined. Thus the casing 71 of the power source device 1 not only shares the improvement in heat radiation properties, the casing 71 has approximately the same temperature as the casing unit 133 and the board 135 in the light-emitting unit 10. Therefore, a temperature rise in the casing unit 133 and the board 135 of the light-emitting unit 10 can be detected by the thermoelectric pair 30b which measures the temperature of the casing 71 in the power source device 1. Thus, irregularities in the light-emitting unit 10 can be detected and security is further improved.

Above, the light-emitting unit 10 which uses solid-state light-emitting devices (LED) and the power source device 1 which is optimal for LED lighting in the lighting apparatus 100 in the present invention can be powered and efficient lighting can be achieved.

Note that it goes without saying that the shape of the present invention can be freely changed as long as the modification does not deviate from the purpose of the invention. For example here the light-emitting unit 10 is a light-emitting diode, however the light-emitting unit 10 is not limited to a diode. An organic electric light (EL) and so on may be used.

Additionally, the thermoelectric pair 30a and the thermoelectric pair 30b are shown as examples for measuring the temperature of the transformer 29 and so on, however another temperature detection element, for example a thermistor, may also be used.

### (Modification)

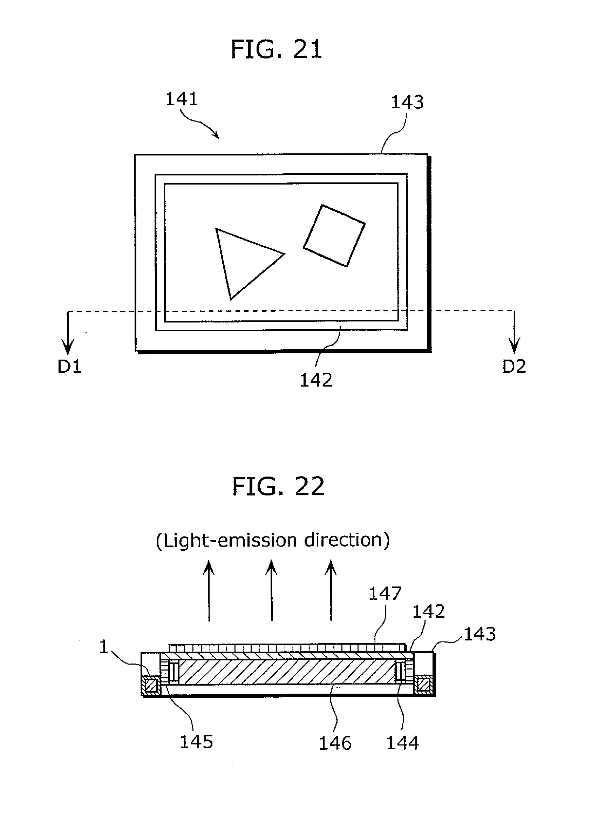

FIG. 21 is a diagram which shows a conceptual view of an advertising display apparatus 141. FIG. 22 is a cross section diagram which shows the structure of D1-D2 in FIG. 21.

The power source device 1 may be applied to an advertising display apparatus 141 as shown in FIG. 21.

The advertising display apparatus 141 is made up of a light-emitting surface 142 and a frame unit 143.

The light-emitting surface 142 has a flat panel structure, utilizes the solid-state light-emitting device 144 as a light source, and the solid-state light-emitting device 144 is attached to the frame unit 143 through the board 145. Light from the solid-state light-emitting device 144 is guided by a light conductor 146 and light is emitted in the light-emission direction shown in FIG. 22.

A film 147 is attached to the surface of the light-emitting layer 142. The film 147 is half-transparent and information such as advertising is written on it. In this way the advertising display apparatus 141 can be used.

Additionally, an infrared remote control (not pictured) can be used to independently adjust the advertising display apparatus 141 by using the power source device 1 as the powering source for the solid-state light-emitting device 144.

### Industrial Applicability

The present invention can be applied to a lighting apparatus and can especially be applied to a lighting apparatus which utilizes a solid-state light-emitting device such as a light-emitting diode as a light source which utilizes an AC power source.

## Claims

1. A lighting apparatus which lights by causing solid-state light-emitting devices to emit light using an AC power source, said lighting apparatus comprising:
a power source device which includes:
an AC to DC conversion unit operable to convert AC voltage from a power source into DC voltage;
a main single-side mounting board having a rectangular shape, on which a part of said AC to DC conversion unit is mounted; and
a first single-side mounting sub-board having a rectangular shape, on which a remaining part of said AC to DC conversion unit is mounted,
wherein said power source device is shaped like a chopstick box and composed such that the mounting surface of said main single-side mounting board and the mounting surface of said first single-side mounting sub-board are laid out such that the mounting surfaces face each other along a length-wise direction.

2. The lighting apparatus according to Claim 1,
wherein said AC to DC conversion unit includes:
an undulating voltage conversion unit operable to convert sine wave voltage from the power source into an undulating voltage; and
a switch unit operable to control a duty cycle which is a ratio between ON time in which, the undulating voltage outputted from said undulating voltage conversion unit is allowed to pass, and OFF time in which the undulating voltage is not allowed to pass;
a transformer operable to transform undulating voltage from said switch unit; and
a smoothing unit operable to smooth the voltage transformed by said transformer.

3. The lighting apparatus according to Claim 2,
wherein said power source device further includes:
a second single-side mounting sub-board;
a photo coupler;
a microcomputer unit operable to control the duty cycle through said photo coupler for said switch unit;
a microcomputer power source unit operable to power said microcomputer unit, and
wherein said microcomputer unit and said microcomputer power source unit are mounted on said second single-side mounting sub-board, and
the mounting surface of said main single-side mounting board and the mounting surface of said second single-side mounting sub-board are laid out so such that mounting surfaces face each other along a length-wise direction.

4. The lighting apparatus according to Claim 1,
wherein a height of said power source device is approximately equal to a height of a first circuit which is the tallest among circuit parts included in said AC to DC conversion unit, and
a length of a short side of said power source device is approximately equal to a length of a second circuit part which is the widest among the circuit parts included in said AC to DC conversion unit.

5. The lighting apparatus according to Claim 4,
wherein a distance between said main single-side mounting board and said first single-side mounting sub-board is approximately equal to a height of the first circuit part, and
the main single-side mounting board and the first single-side mounting sub-board are laid out such that the short-side length of said main single-side mounting board and said first single-side mounting sub-board become approximately equal to a width of the second circuit part.

6. The lighting apparatus according to Claim 4,
wherein the first and the second circuit parts are the same circuit parts and are said transformers.

7. The lighting apparatus according to Claim 3,
wherein said power source device includes
a detecting unit operable to detect temperature,
wherein said microcomputer unit controls said switch unit to shorten the ON time when a temperature detected by said detecting unit exceeds a first temperature.

8. The lighting apparatus according to Claim 3,
wherein said power source device includes
a detecting unit operable to detect temperature, and
said microcomputer unit is operable to control said switch unit to lengthen the ON time when a temperature detected by said detecting unit falls short of a second temperature.

9. The lighting apparatus according to Claim 7 or 8,
wherein the temperature detected by said detecting unit is a temperature of said transformer.

10. The lighting apparatus according to Claim 1,
wherein said power source device includes a casing shaped like a chopstick box, in which said main single-side mounting board and said first single-side mounting sub-board are housed, said casing being small, slim, and rectangular in shape.

11. The lighting apparatus according to Claim 10,
wherein the temperature detected by said detecting unit is a temperature of said casing.

12. The lighting apparatus according to Claim 2,
wherein said power source device further includes a current voltage detecting unit operable to detect voltage and current impressed to the solid-state light-emitting devices from said smoothing unit, and
when a product of the current value and the voltage value detected by said current voltage detecting unit deviates from a predetermined range, said microcomputer unit is operable to control said switch unit to modify the duty cycle.

13. The lighting apparatus according to Claim 12,
wherein said microcomputer unit is operable to control said switch unit to shorten ON time when the product of the current value and the voltage value detected by said current voltage detecting unit exceeds a threshold value.

14. The lighting apparatus according to Claim 12,
wherein said microcomputer unit is operable to control said switch unit such that when a product of the current value and the voltage value detected by said current voltage detecting unit meets a threshold value, the current value becomes the smallest current value at which said solid-state light-emitting devices can emit light.

15. The lighting apparatus according to Claim 3 or 12,
wherein directly after the lighting apparatus is powered on, said microcomputer unit is operable to control said switch unit to successively lengthen ON time until the product of the current value and the voltage value detected by said current voltage unit reaches a target value as an initial process.

16. The lighting apparatus according to Claim 15,
wherein said microcomputer unit is operable to cause a storage unit to store the current value, the voltage value and the duty cycle in the initial process as a history.

17. The lighting apparatus according to Claim 2,
wherein said transformer has a center-tap on a first coil side,
said undulating voltage conversion unit includes a full-wave rectifier operable to output the undulating voltage between an end of a first coil in said transformer and the center-tap, and between another end of the first coil and the center-tap;
said switch unit includes a first switch and a second switch,
said first switch is inserted in wiring which connects said undulating voltage conversion unit and the end of the first coil, and
said second switch is inserted in wiring which connects said undulating voltage conversion unit and the other end of the first coil.

18. The lighting apparatus according to Claim 3,
wherein said microcomputer unit is operable to control starting AC power supply to said AC to DC conversion unit.

19. The lighting apparatus according to Claim 18,
wherein said microcomputer unit is operable to control stopping AC power supply to said AC to DC conversion unit.

20. The lighting apparatus according to Claim 10,
wherein said casing is composed of metal.

21. The lighting apparatus according to Claim 1 and 10,
wherein said lighting apparatus includes a light-emitting unit operable to emit light through the solid-state light-emitting devices,
a holding unit operable to hold the solid-state light-emitting devices in said light-emitting unit;
said light-emitting unit and said holding unit are composed of metal, and
said holding unit and said casing are combined together.

22. A design assistance method for a lighting apparatus which emits light through solid-state light-emitting devices by using a power source device that includes an AC power source, an AC to DC conversion unit which converts AC from the power source into DC, a main single-side mounting board and a first single-side mounting sub-board on which the AC to DC conversion unit is mounted; the power source device being shaped like a chopstick box and composed such that a mounting surface of the long, rectangular main single-side mounting board, on which a part of the AC to DC conversion unit is mounted, and a mounting surface of the first single-side mounting sub-board, on which a remaining part of the AC to DC conversion unit is mounted, are laid out such that the mounting surfaces face each other along a length-wise direction, said design assistance method comprising:
a selection step of creating a list of circuit parts included in the power source device and selecting a first circuit part which is the tallest circuit part and a second circuit part which is the widest circuit part of the circuit parts in the list;
a short side determining step of determining a length of a short side of the main single-side mounting board and the first single-side mounting sub-board in the power source device based on a width of the second circuit part selected in said selection step;
a distance determining step of determining a distance between the main single-side mounting board and the first single-side mounting sub-board as approximately equal to the height of said first circuit part; and
a long side determining step of determining a length of a long side of the main single-side mounting board and the single-side mounting sub-board at which the circuit parts on the list are laid out and mounted to the main single-side mounting board and the first single-side mounting sub-board, given the length of the short side determined in said short-side determining step and the distance determined in said distance determining step.

23. A program product readable by a computer for supporting design of a lighting apparatus which emits light through solid-state light-emitting devices by using a power source device that includes an AC power source, an AC to DC conversion unit which converts AC from the power source into DC, a long, rectangular main single-side mounting board and a first single-side mounting sub-board on which the AC to DC conversion unit is mounted; the power source device being shaped like a chopstick box and composed such that a mounting surface of the main single-side mounting board, on which a part of the AC to DC conversion unit is mounted, and a mounting surface of the first single-side mounting sub-board, on which a remaining part of the AC to DC conversion unit is mounted, are laid out such that the mounting surfaces face each other along a length-wise direction, said program product which, when loaded into a computer, allowing the computer to execute:
a selection step of creating a list of circuit parts included in the power source device and selecting a first circuit part which is the tallest circuit part and a second circuit part which is the widest circuit part of the circuit parts in the list;
a short side determining step of determining a length of a short side of the main single-side mounting board and the first single-side mounting sub-board in the power source device based on a width of the second circuit part selected in said selection step;
a distance determining step of determining a distance between the main single-side mounting board and the first single-side mounting sub-board as approximately equal to the height of said first circuit part; and
a long side determining step of determining a length of a long side of the main single-side mounting board and the single-side mounting sub-board at which the circuit parts on the list are laid out and mounted to the main single-side mounting board and the first single-side mounting sub-board, given the length of the short side determined in said short-side determining step and the distance determined in said distance determining step.
